(19) Europäisches Patentamt
European Patent Office
Office européen des brevets

(11) **EP 4 345 472 A1**

(12) **EUROPEAN PATENT APPLICATION**

(43) Date of publication:
**03.04.2024 Bulletin 2024/14**

(21) Application number: **23193693.1**

(22) Date of filing: **28.08.2023**

(51) International Patent Classification (IPC):
**G01R 31/69** (2020.01)     **G06F 1/16** (2006.01)
**G06F 1/18** (2006.01)

(52) Cooperative Patent Classification (CPC):
**G01R 31/69; G06F 1/1656; G06F 1/181;
G06F 1/182**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **28.09.2022 US 202217955370**

(71) Applicant: **INTEL Corporation
Santa Clara, CA 95054 (US)**

(72) Inventors:
• **THITE, Yogesh
560037 Bangalore (IN)**
• **MULGUND, Prabhanjan
560103 Bangalore (IN)**

(74) Representative: **2SPL Patentanwälte PartG mbB
Landaubogen 3
81373 München (DE)**

(54) **METHODS AND APPARATUS TO DETECT A COMPATIBLE PORT**

(57) Methods, apparatus, systems, and articles of manufacture are disclosed detection circuitry including an inductor and a capacitor; and controller circuitry coupled to the detection circuitry, the controller circuitry configured to: generate a voltage pulse; supply the voltage pulse to the detection circuitry; monitor a characteristic of a detection output of the detection circuitry in response to the voltage pulse; determine a variation in the detection output based on a comparison of the characteristic of the detection output to a threshold value; and determine a type of connector in proximity to the detection circuitry based on the variation.

FIG. 1

**EP 4 345 472 A1**

## Description

FIELD OF THE DISCLOSURE

This disclosure relates generally to ports and, more particularly, to methods and apparatus to detect a compatible port.

BACKGROUND

Ports allow devices to be electrically coupled by a connector. Device designers determine which type of port(s) to include in a device on a device-by-device basis. For example, a designer includes a universal serial bus (USB) port in a laptop design to allow a variety of storage devices, such as a flash drive or a hard drive, and/or control devices, such as a mouse or keyboard, to be electrically coupled to the laptop. Some devices include multiple different types of ports to allow the device to be electrically coupled to a wide range of devices. For example, a laptop may include a USB port, an ethernet port, a charger port, and a high-definition multimedia interface (HDMI) port.

BRIEF DESCRIPTION OF THE DRAWINGS

FIG. 1 is a block diagram of an example system including a device configured to determine an example port that corresponds to an example connector using example detection circuitry and example controller circuitry.

FIG. 2 is a schematic diagram of the device of FIG. 1 including first example detection circuitry of FIG. 1 including and first example controller circuitry of FIG. 1.

FIG. 3 is a block diagram of the first example of the controller circuitry of FIGS. 1 and 2.

FIG. 4A and 4B are timing diagrams of an example operation of the first example of the detection circuitry of FIGS. 1 and 2 and the first example of the controller circuitry of FIGS. 1-3.

FIG. 5 is a schematic diagram of an example of the device of FIGS. 1 and 2 including second example detection circuitry and second example controller circuitry.

FIG. 6 is a block diagram of the second example controller circuitry of FIG. 5.

FIG. 7A and 7B are timing diagrams of an example operation of the second example detection circuitry of FIG. 5 and the second example of the controller circuitry of FIGS. 5 and 6.

FIG. 8 is a schematic diagram of an example of the device of FIGS. 1, 2, and 5 including third example detection circuitry and the second example controller circuitry of FIGS. 5 and 6.

FIG. 9A and 9B are timing diagrams of an example operation of the third example detection circuitry of FIG. 8 and the second example of the controller circuitry of FIGS. 5, 6, and 8.

FIG. 10 is a flowchart representative of example machine readable instructions and/or example operations that may be executed by example processor circuitry to implement the device of FIGS. 1 and 2.

FIG. 11 is a flowchart representative of example machine readable instructions and/or example operations that may be executed by example processor circuitry to implement the devices of FIGS. 5 and 8.

FIG. 12 is a block diagram of an example processing platform including processor circuitry structured to execute the example machine readable instructions and/or the example operations of FIGS. 10 and/or 11 to implement the devices of FIGS. 1, 2, 5, and/or 8.

FIG. 13 is a block diagram of an example implementation of the processor circuitry of FIG. 12.

FIG. 14 is a block diagram of another example implementation of the processor circuitry of FIG. 12.

In general, the same reference numbers will be used throughout the drawing(s) and accompanying written description to refer to the same or like parts. The figures are not to scale.

As used herein, unless otherwise stated, the term "above" describes the relationship of two parts relative to Earth. A first part is above a second part, if the second part has at least one part between Earth and the first part. Likewise, as used herein, a first part is "below" a second part when the first part is closer to the Earth than the second part. As noted above, a first part can be above or below a second part with one or more of: other parts therebetween, without other parts therebetween, with the first and second parts touching, or without the first and second parts being in direct contact with one another.

As used herein, connection references (e.g., attached, coupled, connected, and joined) may include intermediate members between the elements referenced by the connection reference and/or relative movement between those elements unless otherwise indicated. As such, connection references do not necessarily infer that two elements are directly connected and/or in fixed relation to each other. As used herein, stating that any part is in "contact" with another part is defined to mean that there is no intermediate part between the two parts.

Unless specifically stated otherwise, descriptors such as "first," "second," "third," etc., are used herein without imputing or otherwise indicating any meaning of priority, physical order, arrangement in a list, and/or ordering in any way, but are merely used as labels and/or arbitrary names to distinguish elements for ease of understanding the disclosed examples. In some examples, the descriptor "first" may be used to refer to an element in the detailed description, while the same element may be referred to in a claim with a different descriptor such as "second" or "third." In such instances, it should be understood that such descriptors are used merely for identifying those elements distinctly that might, for example, otherwise share a same name.

As used herein, "approximately" and "about" modify their subjects/values to recognize the potential presence of variations that occur in real world applications. For example, "approximately" and "about" may indicate such dimensions may be within a tolerance range of +/- 10% unless otherwise specified in the below description. As used herein "substantially real time" refers to occurrence in a near instantaneous manner recognizing there may be real world delays for computing time, transmission, etc. Thus, unless otherwise specified, "substantially real time" refers to real time +/- 1 second.

As used herein, the phrase "in communication," including variations thereof, encompasses direct communication and/or indirect communication through one or more intermediary components, and does not require direct physical (e.g., wired) communication and/or constant communication, but rather additionally includes selective communication at periodic intervals, scheduled intervals, aperiodic intervals, and/or one-time events.

As used herein, "processor circuitry" is defined to include (i) one or more special purpose electrical circuits structured to perform specific operation(s) and including one or more semiconductor-based logic devices (e.g., electrical hardware implemented by one or more transistors), and/or (ii) one or more general purpose semiconductor-based electrical circuits programmable with instructions to perform specific operations and including one or more semiconductor-based logic devices (e.g., electrical hardware implemented by one or more transistors). Examples of processor circuitry include programmable microprocessors, Field Programmable Gate Arrays (FPGAs) that may instantiate instructions, Central Processor Units (CPUs), Graphics Processor Units (GPUs), Digital Signal Processors (DSPs), XPUs, or microcontrollers and integrated circuits such as Application Specific Integrated Circuits (ASICs). For example, an XPU may be implemented by a heterogeneous computing system including multiple types of processor circuitry (e.g., one or more FPGAs, one or more CPUs, one or more GPUs, one or more DSPs, etc., and/or a combination thereof) and application programming interface(s) (API(s)) that may assign computing task(s) to whichever one(s) of the multiple types of processor circuitry is/are best suited to execute the computing task(s).

DETAILED DESCRIPTION

Some example devices include multiple different types of ports to support a wide range of devices. For example, a laptop may include a USB port, a display port, and a charging port. Each type of port corresponds to a compatible connector. Connectors electrically couple one type of port to another port. Typically, a connector only has one type of compatible port. For example, an HDMI connector is compatible with an HDMI port and incompatible with a display port. Some such types of ports include, but are not limited to, a USB port, an ethernet port, a charger port, an HDMI port, etc.

Designers often place one or more ports in close proximity with each other to decrease a size of a device. In devices with multiple types of ports, placing ports in such a proximity requires users to determine a precise location of a port that corresponds to a selected connector. In some examples, users determine a location of a compatible port based on a visual observation of the ports. However, some devices, such as a personal computer, a laptop, etc., place ports in locations which are visually difficult to observe. For example, laptops typically place a plurality of ports on a side of the laptop that faces away from a user. In such devices, users may either determine a location of a port by incurring the difficultly of making a visual observation or by determining the location of the port by making a physical observations, such as touch.

Example systems, methods, and apparatus disclosed herein include detection circuitry and controller circuitry configured to determine a compatible port corresponding to a type of a connector as the connector approaches a device. In some described examples, the detection circuitry enables controller circuitry to determine and indicate whether a connector is in proximity to a port that is compatible with the connector. Such an indication increases a user's experience with a device and reduces difficultly with locating a compatible port when in proximity to a plurality of other ports.

The example detection circuitry includes an internal inductance and an internal capacitance. The example detection circuitry modifies characteristics of a detection output based on the internal inductance and internal capacitance. The example detection circuitry generates a response to a voltage pulse based on variations to the internal inductance.

An amount of metal used to manufacture a connector varies based on a type of connector. Each type of connector varies the internal inductance by a different amount based on the amount of metal comprising the connector. Variations in the internal inductance modify one or more characteristics of the detection circuitry. Such variations allow the controller circuitry to differentiate between types of connectors. An inductor is placed in proximity to a port to allow the internal inductance to vary as connectors approach the port. The device generates a first indication in response to a connector approaching a port that is compatible with the connector. The device generates a second indication in response to the connector approaching a port that is incompatible with the connector.

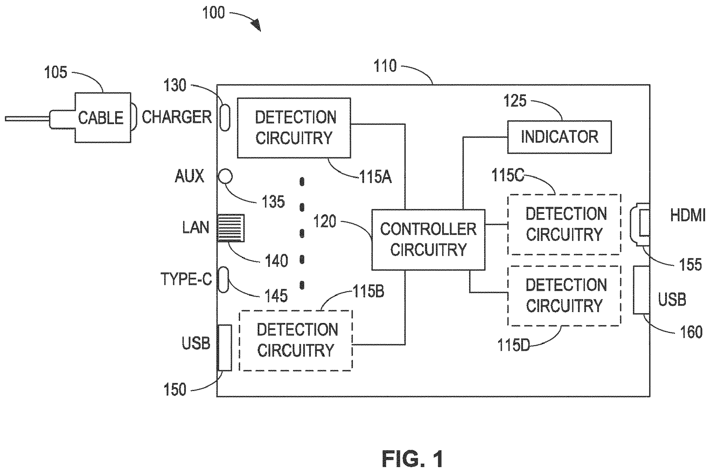

FIG. 1 is a block diagram of an example system 100 configured to indicate whether an example connector 105 that is approaching an example device 110 is approaching a compatible port. In the example of FIG. 1, the system 100 includes the connector 105 and the device 110. The device 110 determines if the connector 105 is approaching one or more example detection circuitry 115A-115D in proximity to one or more compatible port(s).

In the example of FIG. 1, the device 110 includes first example detection circuitry 115A, second example detection circuitry 115B, third example detection circuitry 115C, fourth example detection circuitry 115D, example controller circuitry 120, an example indicator 125, an example charger port 130, an example audio jack port (AUX) 135, an example ethernet port (LAN) 140, an example USB type-C port (TYPE-C) 145, a first example USB type-A port 150, an example HDMI port (HDMI) 155, and a second example USB type-A port (USB) 160. The example device 110 is configured to determine whether the connector 105 is approaching a compatible port. The example device 110 determines a compatible port to be one or more of the ports 130-160 based on the detection circuitry 115A-115D. The example device 110 indicates to a user (not illustrated) whether the connector 105 is approaching the compatible port by the indicator 125.

The connector 105 is configured to electrically couple the device 110 to another device (not illustrated). The connector 105 is a type of connector which corresponds to one of the ports 130-160. For example, the connector 105 corresponds to the first USB type-A port 150 when the type of connector is a USB type-A connector. The port which corresponds to the type of the connector 105 is referred to as a compatible port. The connector 105 may be referred to as a cable, a cord, a communication line, etc.

The detection circuitry 115A-115D are placed in proximity to one or more of the ports 130-160. For example, the first detection circuitry 115A is placed near the charger port 130, the second detection circuitry 115B is placed near the first USB type-A port 150, the third detection circuitry 115C is placed near the HDMI port 155, and the fourth detection circuitry 115D is placed near the second USB type-A port 160. Alternatively, the detection circuitry 115A-115D may be placed in proximity to more than one of the ports 130-160. For example, the device 110 includes the first detection circuitry 115A in proximity to the charger port 130 and the audio jack port 135. The detection circuitry 115A-115D are placed in enough of a proximity to one or more of the ports 130-160 that the connector 105 enters a magnetic field of the detection circuitry 115A-115D when approaching one of the ports 130-160.

The detection circuitry 115A-115D are electrically coupled to the controller circuitry 120. The detection circuitry 115A-115D are configured to generate a detection output in response to a voltage pulse input, from the controller circuitry 120. The detection circuitry 115A-115D modifies characteristics of the detection output in response to the connector 105 being near the detection circuitry 115A-115D. For example, the first detection circuitry 115A modifies a voltage of the detection output in response to the connector 105 approaching the charger port 130. The detection circuitry 115A-115D further modifies the detection output based on an amount of metal comprising the connector 105.

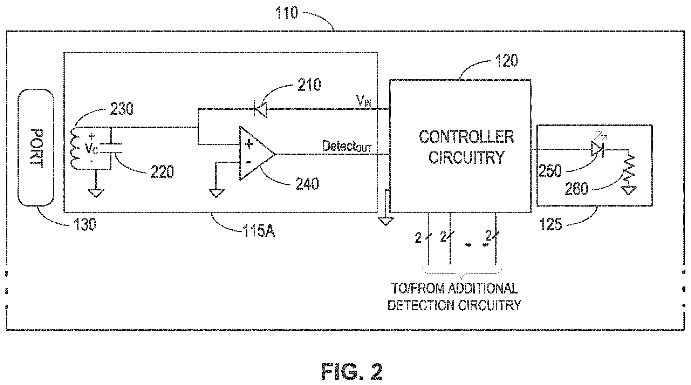

The detection circuitry 115A-115D includes an internal inductance (illustrated in connection with FIGS. 2, 5, and 8 below) and an internal capacitance (illustrated in connection with FIGS. 2, 5, and 8 below). The detection circuitry 115A-115D generates the detection output in response to a voltage pulse input from the controller circuitry 120. The voltage pulse input induces the detection circuitry 115A-115D to generate a magnetic field using the internal inductance.

As the connector 105 approaches one of the detection circuitry 115A-115D, the metal comprising the connector 105 causes variations in the magnetic field. The variations in the magnetic field modifies the internal inductance. For example, additional metal entering the magnetic field may cause variations in current flowing through the internal inductance, voltage differences across the internal inductance, and/or power to be induced in an inductor.

The detection circuitry 115A-115D modifies characteristics of the detection output as a result of variations in the internal inductance. For example, an increase in the internal inductance of the first detection circuitry 115A increases a voltage across the internal capacitance. In another example, an increase in the internal inductance of the first detection circuitry 115A increases a resonant frequency of an oscillation between the internal inductance and the internal capacitance. In yet another example, decreasing a proximity between a metal conductor and the internal inductance of the first detection circuitry 115A magnetically couples the internal inductance to another inductor. The detection circuitry 115A-115D supplies the detection output to the controller circuitry 120 in response to a voltage pulse from the controller circuitry 120.

The controller circuitry 120 is electrically coupled to the detection circuitry 115A-115D and the indicator 125. The controller circuitry 120 may be communicatively coupled to the indicator 125. The controller circuitry 120 is configured to initiate detection of the connector 105 by generating a voltage pulse. The controller circuitry 120 supplies the voltage pulse to one or more of the detection circuitry 115A-115D. The controller circuitry 120 monitors characteristics of the detection output from the detection circuitry 115A-115D, such as a voltage, an average voltage, a frequency, etc.

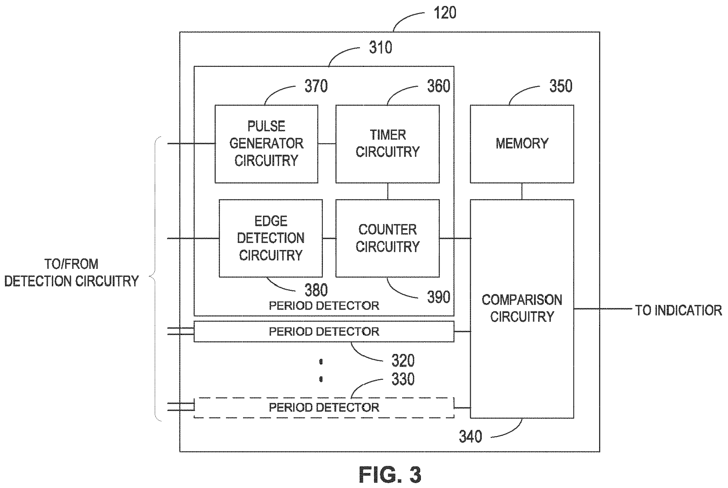

The example controller circuitry 120 monitors, measures, and compares characteristics of the voltage of the detection output to determine variations in the internal inductance of detection circuitry. For example, the controller circuitry 120 may determine a change in resonant frequency by determining a time between two sequential reference crossings. In such an example, the controller circuitry 120 determines a period of the detection output by determining a time between sequential zero-crossings where a voltage of the detection output is approximately equal to a common potential (e.g., ground). Such an example is further discussed in connection with FIGS. 2 and 3, below.

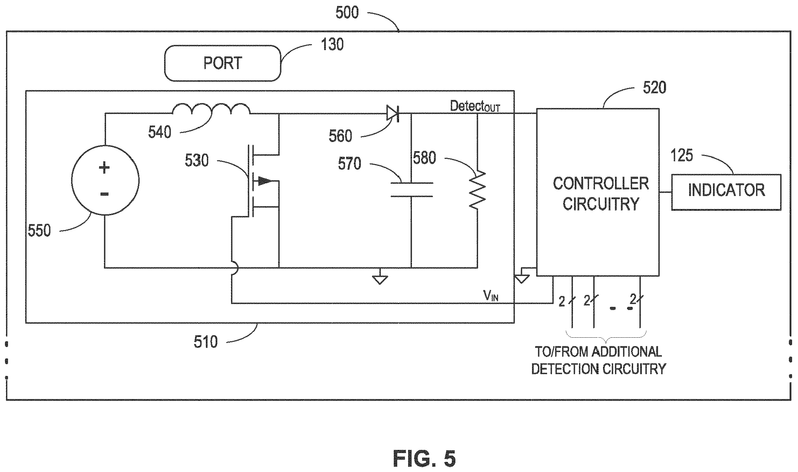

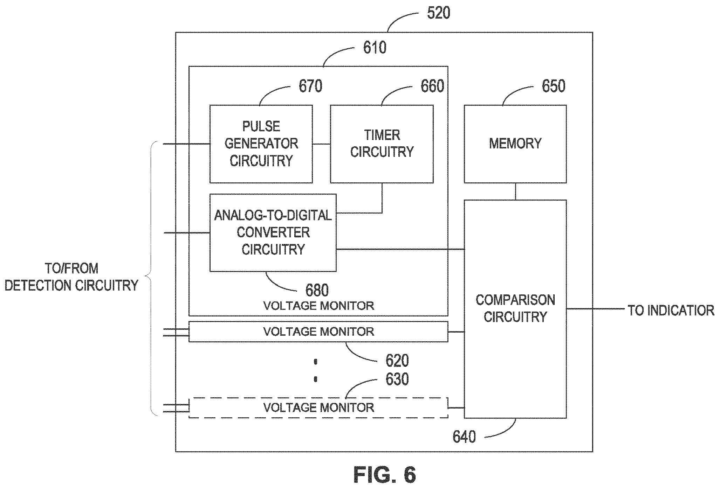

In another example, the controller circuitry 120 may determine a change in the internal inductance of detection circuitry by detecting variations in an average voltage and/or a local maximum of a voltage of the detection output. In such an example, the internal capacitance sets the detection output to a different voltage in response to changes in current caused by a variation of the internal inductance. Such an example is further discussed in connection with FIGS. 5 and 6, below.

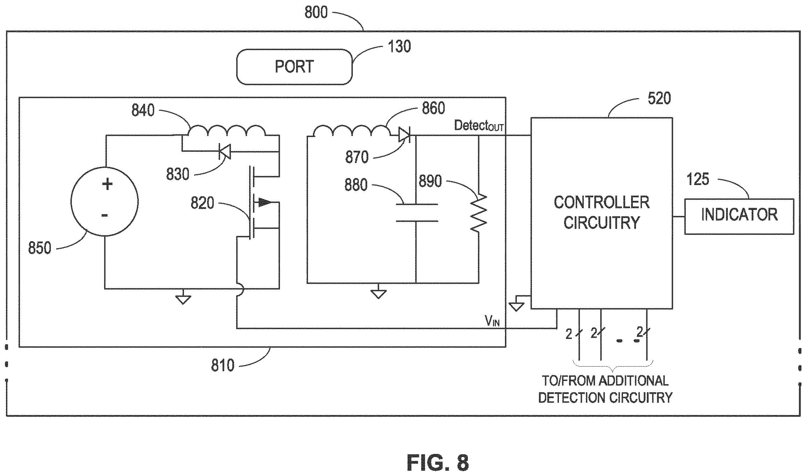

In yet another example, the controller circuitry 120 may determine a change in the internal inductance of detection circuitry when variations in a voltage of the detection output are greater than a threshold value. In such an example, the internal capacitance sets the detection output when approaching metal of the connector 105 magnetically couples two inductors. Such an example is further discussed in connection with FIG. 8, below.

The controller circuitry 120 monitors the characteristics of the detection output to increase a likelihood of detecting the connector 105. For example, continuous monitoring enables the controller circuitry 120 to detect variations in the voltage and/or resonant frequency of the detection output. The controller circuitry 120 compares the characteristics of the voltage of the detection output without the connector 105 approaching to measured characteristics to determine whether the connector 105 is approaching the device 110.

For example, the controller circuitry 120 determines the connector 105 is approaching one of the ports 130-160 when a measured period of the detection output varies and/or differs from an expected period. In such an example, the expected period corresponds to a period generated by the internal inductance and internal capacitance while the connector 105 is not approaching the device 110. Such an expected period may be determined and/or configured as a resonant frequency of the circuitry comprising the detection circuitry 115A-115D.

In another example, the controller circuitry 120 determines the connector 105 is approaching on the of the ports 130-160 when a measured voltage of the detection output is greater than an expected voltage. In such an example, the expected voltage corresponds to a voltage measured by the controller circuitry 120 when the connector 105 was not approaching the device 110.

The controller circuitry 120 determines whether the connector 105 is approaching a compatible port by determining a type of the connector 105. The controller circuitry 120 determines the type of the connector 105 based on a magnitude of the variations in the internal inductance. For example, a USB type-A connector varies the internal inductance by a first magnitude, while an HDMI connector varies the internal inductance by a second magnitude. In such an example, an increase in the amount of metal comprising the HDMI connector from the USB type-A, results in more metal in the magnetic field of the internal inductances. The controller circuitry 120 determines the type of the connector 105 by comparing a magnitude of a variation in the internal inductance to reference values and/or reference ranges of values.

The controller circuitry 120 is configured to select the type of the connector 105 based on configured and/or determined values which correspond to example connectors. For example, the controller circuitry 120 determines the connector 105 is a charger by comparing the period between reference crossings to a reference charger period corresponding to example charger connectors.

In another example, the controller circuitry 120 determines the connector 105 is a charger by comparing the voltage of the detection output to ranges of reference detection output voltages which correspond to each type of connector. The controller circuitry 120 may be configured, calibrated, and/or programmed with reference values which correspond to different type of connectors during design and/or manufacture of the device 110.

The example controller circuitry 120 compares the determined type of the connector 105 to the types of the ports 130-160. The controller circuitry 120 generates a first indication when the determined type of the connector 105 corresponds to the one or more of the ports 130-160 in proximity the detection circuitry 115A-115D which supplied the detection output. The first indication corresponds to the controller circuitry 120 determining the connector 105 is approaching a compatible port. For example, the controller circuitry 120 generates the first indication if the connector 105 is determined to be a charger connector and is determined to be approaching the first detection circuitry 115A which corresponds to the charger port 130.

The controller circuitry 120 generates a second indication when the determined type of the connector 105 fails to correspond to the one or more of the ports 130-160 in proximity the detection circuitry 115A-115D which supplied the detection output. The second indication corresponds to the controller circuitry 120 determining the connector 105 is approaching an incompatible port. For example, the controller circuitry 120 generates the second indication if the connector 105 is determined to be a USB connector and is determined to be approaching the first detection circuitry 115A which corresponds to the charger port 130. The example controller circuitry 120 supplies the first indication and/or the second indication to the indicator 125.

The indicator 125 is electrically coupled to the controller circuitry 120. The indicator 125 indicates that the connector 105 is approaching a compatible port based on the first indication from the controller circuitry 120. The indicator 125 indicates that the connector 105 is approaching an incompatible port based on the second indication from the controller circuitry 120. The indicator 125 is configured to indicate the first indication and the second indication from the controller circuitry 120 to a user, operating system, software container, etc. The indicator 125 may be a visual indication, such as illuminating a light emitting diode (LED), a generating a notification on a display, displaying text on a liquid-crystal display (LCD), etc. The indicator 125 may be an audio indication, such as generating an audible sound. An example of the indicator 125 is illustrated in connection with FIG. 2, below.

FIG. 2 is a schematic diagram of the device 110 of FIG. 1 including a first example implementation of the detection circuitry 115A-115D of FIG. 1. In the example of FIG. 2, the device 110 includes the first detection circuitry 115A, the controller circuitry 120 of FIG. 1, the indicator 125 of FIG. 1, and the charger port 130 of FIG. 1. The device 110 determines whether a connector (e.g., the connector 105 of FIG. 1) is approaching the charger port 130 based on the first detection circuitry 115A. The device 110 indicates whether an approaching connector is compatible with the charger port 130.

Although in the example of FIG. 2, the device 110 is illustrated in connection with an example implementation of the first detection circuitry 115A, the device 110 may include one or more of the first detection circuitry 115A, such as for the detection circuitry 115B-115D of FIG. 1.

The first detection circuitry 115A is electrically coupled to the controller circuitry 120. The first detection circuitry 115A is configured to be magnetically coupled to a connector in proximity to the charger port 130. In the example of FIG. 2, the first detection circuitry 115A includes an example diode 210, an example capacitor 220, an example inductor 230, and an example amplifier 240. The first detection circuitry 115A generates a detection output (Detect$_{OUT}$) in response to a voltage pulse input (V$_{IN}$).

The diode 210 is coupled to the controller circuitry 120, the capacitor 220, the inductor 230, and the amplifier 240. The diode 210 is configured to allow current to flow from the controller circuitry 120 to the capacitor 220 and the inductor 230. The diode 210 prevents current from flowing to the controller circuitry 120. The diode 210 supplies the voltage pulse input to the capacitor 220, the inductor 230, and the amplifier 240.

The capacitor 220 is coupled to the diode 210, the inductor 230, the amplifier 240, and a common potential (e.g., ground). The capacitor 220 includes a capacitance, which is referred to as the internal capacitance of the detection circuitry 115A-115D in FIG. 1. The capacitor 220 is configured to store charge from the voltage pulse input. The capacitor 220 is configured to discharge following a falling edge of the voltage pulse supplied to the voltage pulse input. For example, the controller circuitry 120 generates a falling edge by transitioning the voltage pulse input from a voltage above common potential to approximately common potential. The capacitor 220 supplies current to the inductor 230 while discharging.

The inductor 230 is coupled to the diode 210, the capacitor 220, the amplifier 240, and the common potential. The inductor 230 includes an inductance, which is referred to as the internal inductance of the detection circuitry 115A-115D in FIG. 1. The inductor 230 is configured to store a charge from the voltage pulse input. For example, the inductor 230 initially prevents current from the diode 210 being supplied to common ground, however the inductor 230 gradually allows current to flow to common potential. The inductor 230 is configured to discharge a current towards common potential following the falling edge of the voltage pulse input.

In example operation, following the voltage pulse from the controller circuitry 120, the capacitor 220 and the inductor 230 gradually discharge and charge each other until enough charge has dissipated to prevent the capacitor 220 from being charged by the inductor 230.

At a first time, the controller circuitry 120 sets the voltage pulse input equal to the common potential. At the first time, the capacitor 220 resists the change in voltage to common potential and gradually discharges by supplying current to the common potential through the inductor 230. Beginning at the first time, the capacitor 220 charges the inductor 230.

At a second time, the capacitor 220 has discharged enough current through to the inductor 230 such that a voltage (Vc) across the capacitor 220 is approximately equal to the common potential. At the second time, the capacitor 220 stops supplying current to the inductor 230 to hold the voltage across the capacitor 220 equal to the common potential. At the second time, the inductor 230 gradually reduces the current being supplied to the common potential towards approximately zero amps, which continues to discharge the capacitor 220. At the second time, the inductor 230 continues to pull current from the capacitor 220 which decreases the voltage across the capacitor 220 to be less than the common potential.

At a third time, the capacitor 220 resists the change in voltage from being approximately equal to common potential to less than the common potential. At the third time, the capacitor 220 pulls current from the common potential through the inductor 230 to set the voltage across the capacitor 220 to be approximately equal to the common potential. At the third time, the capacitor 220 begins to charge.

At a fourth time, the capacitor 220 stops pulling current from the common potential in response to the voltage across the capacitor 220 being equal to the common potential. Beginning at the third time, the inductor 230 gradually decreases the current being supplied to the capacitor 220 from the common potential to resist the change in current being pulled by the capacitor 220, which continues to charge the capacitor 220.

At a fifth time, the inductor 230 stops supplying current to the capacitor 220 from common ground. At the fifth time, the capacitor 220 starts to discharge energy stored between the fourth time and the fifth time to return the voltage across the capacitor 220 to be approximately equal to common potential. At the fifth time, the capacitor 220 supplies current to the common potential through the inductor 230.

At a sixth time, the capacitor 220 stops supplying current to the inductor 230 in response to the voltage across the capacitor 220 being approximately equal to common potential. Beginning at the sixth time, the inductor 230 gradually reduces the current being supplied to the common potential from the capacitor 220, which continues to discharge the capacitor 220 to a voltage less than the common potential.

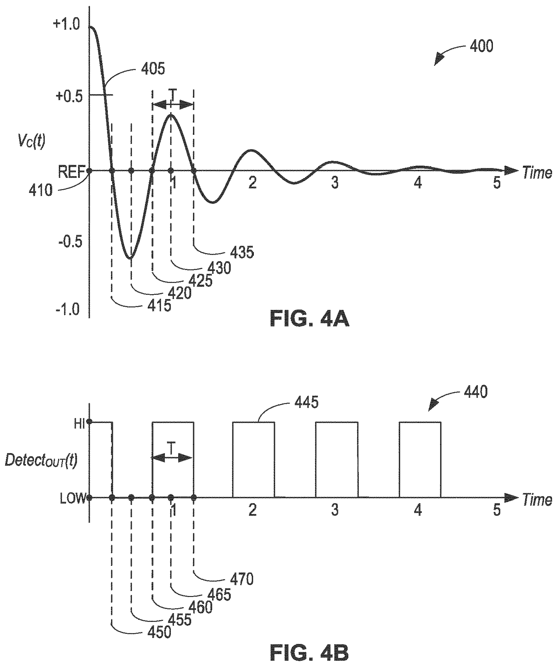

Such charging and discharging of the capacitor 220 by the inductor 230 causes the voltage across the capacitor 220 to oscillate at over time, until the voltage across the capacitor 220 has settled. Such an oscillation may be illustrated as a dampening sinusoidal waveform. The frequency of the oscillation is referred to as a resonant frequency. The resonant frequency is based on the capacitance of the capacitor 220 and the inductance of the inductor 230. The voltage across the capacitor 220 is illustrated in connection with FIGS. 4A and 4B, below.

The controller circuitry 120 uses the time between the fourth time and the sixth time to determine whether a connector is approaching the device 110 and determine the type of the connector. The controller circuitry 120 determines the difference between the fourth time and the sixth time is a period (T) which is modified by variations in the capacitance (C) of the capacitor 220 and the inductance (L) of the inductor 230. The period corresponds to the resonant frequency of the first detection circuitry 115A. The controller circuitry 120 determines a period corresponding to a connector in proximity of the first detection circuitry 115A by multiplying pi ($\pi$) by a square root of a multiplication of the capacitance of the capacitor 220 and the inductance of the inductor 230. The controller circuitry 120 may determine the period between the fourth time and the sixth time using Equation (1), below. Equation (1) illustrates how variations in the inductance may vary the period between reference crossings.

$$T = \pi\sqrt{LC} \qquad \text{Equation (1)}$$

The controller circuitry 120 may use Equation (1), above, to determine whether the connector 105 is approaching the first detection circuitry 115A. For example, the controller circuitry 120 may determine a variation in the period greater than a threshold value from a reference period corresponds to a connector approaching. For example, the controller circuitry 120 determines a connector approaching one or more of the ports 130-160 following a determination that the period between the fourth time and the sixth time has changed by a value greater than a threshold. In such an example, the threshold may be set at a time of manufacture and/or calibrated during run-time operations.

The amplifier 240 is electrically coupled to the controller circuitry 120, the diode 210, the capacitor 220, the inductor 230, and the common potential. The amplifier 240 includes a non-inverting input (+) and an inverting input (-). The non-inverting input of the amplifier 240 is coupled to the diode 210, the capacitor 220, and the inductor 230. The inverting input of the amplifier 240 is coupled to the common potential. The amplifier 240 is configured to compare a voltage of the non-inverting input to a voltage of the inverting input. The amplifier 240 sets the detection output equal to a logic high while the voltage of non-inverting input is greater than the voltage of the inverting input. The amplifier 240 sets the detection output equal to a logic low while the voltage of non-inverting input is less than the voltage of the inverting input.

The amplifier 240 enables the controller circuitry 120 to determine the period of the detection output as a time between the detection output being set to a logic high and the detection output being set to a logic low. The controller circuitry 120 may include circuitry to determine the duration of time the detection output is a logic high or a logic low to determine variations in the inductance of the inductor 230.

The indicator 125 is electrically coupled to the controller circuitry 120. The indicator 125 includes an example LED 250 and an example resistor 260. The indicator 125 generates visual indications using the LED 250 based on the controller circuitry 120.

The LED 250 is coupled between the controller circuitry 120 and the resistor 260. The LED 250 is configured to emit light of a first color in response to the first indication from the controller circuitry 120. For example, the LED 250 emits green light to indicate that an approaching connector is in proximity to a compatible port. The LED 250 is configured to emit light of a second color in response to the second indication from the controller circuitry 120. For example, the LED 250 emits red light to indicate that an approaching connector is in proximity to an incompatible port. The controller circuitry 120 may be configured to blink the LED 250 to indicate the first detection circuitry 115A detecting a connector approaching.

The resistor 260 is coupled between the LED 250 and the common potential. The resistor 260 is configured to limit current flowing through the LED 250. The resistor 260 may be referred to as a current limiting resistor.

Although an example implementation of the indicator 125 is illustrated in connection with FIG. 2, another method of generating an indication may be used in accordance with the teachings herein. For example, the indicator may be text on a display, an audible sound, a software routine interrupt, etc.

FIG. 3 is a block diagram of a first example of the controller circuitry 120 of FIGS. 1 and 2. The first example of the controller circuitry 120 of FIGS. 1 and 2 may be instantiated (e.g., creating an instance of, bring into being for any length of time, materialize, implement, etc.) by processor circuitry such as a central processing unit executing instructions. Additionally or alternatively, the first example of the controller circuitry 120 of FIGS. 1-3 may be instantiated (e.g., creating an instance of, bring into being for any length of time, materialize, implement, etc.) by an ASIC or an FPGA structured to perform operations corresponding to the instructions. It should be understood that some or all of the circuitry of FIG. 3 may, thus, be instantiated at the same or different times. Some or all of the circuitry may be instantiated, for example, in one or more threads executing concurrently on hardware and/or in series on hardware. Moreover, in some examples, some or all of the circuitry of FIG. 3 may be implemented by microprocessor circuitry executing instructions to implement one or more virtual machines and/or containers.

In the example of FIG. 3, the controller circuitry 120 includes a first example period detector 310, a second example period detector 320, a third example period detector 330, an example comparison circuitry 340, and an example memory 350. The controller circuitry 120 is configured to be coupled to one or more of the detection circuitry 115A-115D. Although in the example of FIG. 3 the controller circuitry 120 includes the period detectors 310-330, the controller circuitry 120 may be modified to include a plurality of the period detectors 310-330 configured to be coupled to one or more of the detection circuitry 115A-115D.

The first period detector 310 is configured to be coupled to one or more of the detection circuitry 115A-115D. In the example of FIG. 3, the first period detector 310 includes example timer circuitry 360, example pulse generator circuitry 370, example edge detection circuitry 380, and example counter circuitry 390. The example period detector 310 generates a voltage pulse to initiate the detection output of the detection circuitry 115A-115D. The example period detector 310 determines a duration the detector output is a logic high and/or a logic low. Alternatively, the example period detector 310 may be configured to determine a duration between reference crossings of the detection output by determining a location of a plurality of reference crossings.

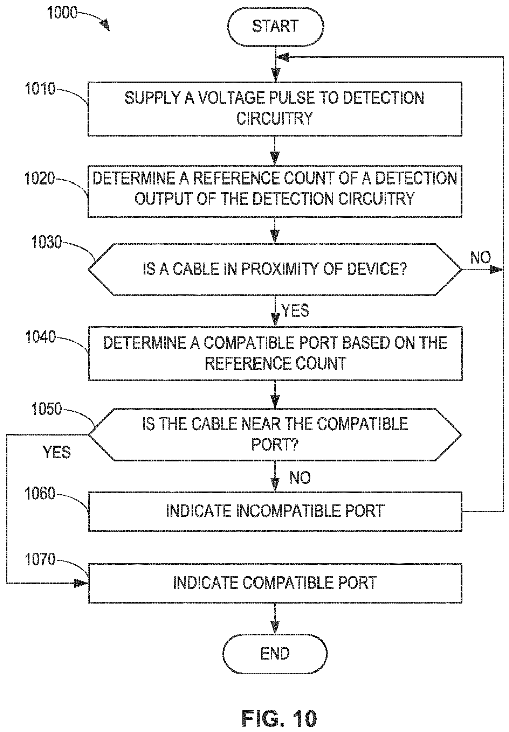

The timer circuitry 360 is coupled to the pulse generator circuitry 370 and the counter circuitry 390. The timer circuitry 360 generates a reference clock of a predetermined frequency. The timer circuitry 360 may be a resistor-capacitor (RC) clock, a crystal oscillator, a voltage controlled oscillator, etc. The timer circuitry 360 supplies the reference clock to the pulse generator circuitry 370 and the counter circuitry 390. In some examples, the timer circuitry 360 is instantiated by processor circuitry executing timing instructions and/or configured to perform operations such as those represented by the flowchart of FIG. 10.

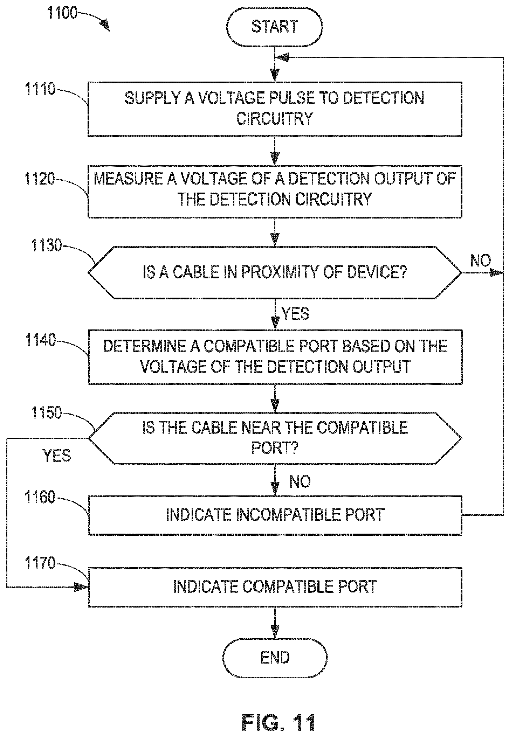

The pulse generator circuitry 370 is configured to be coupled to one of the detection circuitry 115A-115D and the timer circuitry 360. The pulse generator circuitry 370 generates a voltage pulse. The pulse generator circuitry 370 may generate a pulse width modulation (PWM) signal as a chain of sequential voltage pulses of a duration corresponding to a duty cycle. The pulse generator circuitry 370 supplies the voltage pulse to at least one of the detection circuitry 115A-115D by the voltage pulse input ($V_{IN}$). In some examples, the pulse generator circuitry 370 is instantiated by processor circuitry executing generation instructions and/or configured to perform operations such as those represented by the flowchart of FIGS. 10 and 11.

The edge detection circuitry 380 is configured to be coupled to one of the detection circuitry 115A-115D and the counter circuitry 390. The edge detection circuitry 380 determines a rising edge or a falling edge of the detection output of one of the detection circuitry 115A-115D. The edge detection circuitry 380 supplies the counter circuitry 390 with an indication of a rising edge or a falling edge. In some examples, the edge detection circuitry 380 is instantiated by processor circuitry executing detection instructions and/or configured to perform operations such as those represented by the flowchart of FIGS. 10 and/or 11.

The counter circuitry 390 is coupled to the comparison circuitry 340, the timer circuitry 360, and the edge detection circuitry 380. The counter circuitry 390 generates a reference count by counting a number of cycles of the reference clock, from the timer circuitry 360, between edges of the detection output, from the edge detection circuitry 380. The counter circuitry 390 supplies the reference count to the comparison circuitry 340. In some examples, the counter circuitry 390 is instantiated by processor circuitry executing counter instructions and/or configured to perform operations such as those represented by the flowchart of FIGS. 10 and/or 11.

Although the first period detector 310 is illustrated in FIG. 3, the controller circuitry 120 may include one or more instances of the first period detector 310 coupled to one or more of the detection circuitry 115A-115D. The period detectors 320 and 330 include circuitry substantially similar to the first period detector 310.

The comparison circuitry 340 is configured to be coupled to the indicator 125, the period detectors 310-330, the memory 350, and the counter circuitry 390. The comparison circuitry 340 determines whether a connector is approaching the device 110 based on the reference count from the counter circuitry 390. For example, the comparison circuitry 340 determines a connector is approaching when the reference count is less than a first threshold value or greater than a second threshold value. In such an example, the threshold values are stored in the memory 350 and may be determined at a time of manufacture, as a result of calibrations, and/or during run-time operations of the device 110. The comparison circuitry 340 generates a first indication when the comparator determines a connector is approaching the device 110.

The comparison circuitry 340 determines a type of the connector based on the reference count from one of the period detectors 310-330 and reference values in the memory 350. The comparison circuitry 340 selects the type of a connector by determining an interval corresponding to a type of connector containing the reference count. For example, the comparison circuitry 340 may determine the connector is a USB type-A cable when the reference count is seventy-five and the interval corresponding to USB type-A cables is reference counts between sixty-five and ninety.

The comparison circuitry 340 determines if a port corresponding to the first detection circuitry 115A, which was used to generate the reference count, is a compatible port by comparing a type of the port to the determined type of the connector. The comparison circuitry 340 generates a second indication representative of a determination that the type of port is incompatible with the type of connector. The comparison circuitry 340 generates a third indication representative of a determination that the type of port is compatible with the type of connector. In some examples, the comparison circuitry 340 is instantiated by processor circuitry executing comparison instructions and/or configured to perform operations such as those represented by the flowchart of FIGS. 10 and/or 11.

The memory 350 is coupled to the comparison circuitry 340. The memory 350 stores a plurality of intervals corresponding to types of connectors and data representing which of the detection circuitry 115A-115D corresponds to which type of port. For example, the memory 350 stores a look-up table including a plurality of connector types linked to intervals of which the reference count corresponds to that type of connector. In another example, the memory 350 stores a look-up table including data indicating a type of port for each of the ports in proximity to the detection circuitry 115A-115D. The memory 350 includes intervals which have been set by a manufacturer, calibrated, determined by the device 110, etc. The memory 350 allows the comparison circuitry 340 to access interval data and port type data to determine a compatible port.

FIG. 4A and 4B are timing diagrams of an example operation of the first example of the first detection circuitry 115A of FIGS. 1 and 2. FIG. 4A is a timing diagram 400 of an example operation of the first implementation of the first detection circuitry 115A of FIGS. 1 and 2. In the example of FIG. 4A, the timing diagram 400 illustrates a capacitor voltage (Vc) 405 over time. The capacitor voltage 405 represents the voltage across the capacitor 220 of FIG. 2 following the controller circuitry 120 of FIGS. 1-3 supplying a voltage pulse to the first detection circuitry 115A.

At a first time 410, the capacitor voltage 405 begins to decrease in response to a falling edge of the voltage pulse from the controller circuitry 120. At the first time 410, the capacitor 220 resists the change in voltage to common potential and begins to gradually discharge by supplying current to the common potential through the inductor 230 of FIG. 2.

At a second time 415, the capacitor 220 has discharged enough current through to the inductor 230 such that the capacitor voltage 405 is approximately equal to a reference potential (REF). At the second time 415, the inductor 230 gradually reduces the current being supplied to the common potential towards zero amps, which continues to discharge the capacitor 220. At the second time, the inductor 230 continues to pull current from the capacitor 220 which decreases the capacitor voltage 405 to less than the reference potential.

At a third time 420, the capacitor 220 resists the change in the capacitor voltage 405 from being approximately equal to common potential (at the second time 415) to less than the common potential. At the third time 420, the capacitor 220 pulls current from the common potential through the inductor 230 to increase the capacitor voltage 405 to be approximately equal to the common potential. At the third time 420, the capacitor 220 begins to charge.

At a fourth time 425, the capacitor 220 stops pulling current from the common potential in response to the capacitor voltage 405 being equal to the reference potential. At the fourth time 425, the inductor 230 gradually decreases the current being supplied to the capacitor 220 from the common potential to resist the change in current being pulled by the capacitor 220, which continues to charge the capacitor 220 and increase the capacitor voltage 405.

At a fifth time 430, the inductor 230 stops supplying current to the capacitor 220 from common ground. At the fifth time 430, the capacitor 220 starts to discharge energy stored between the fourth time 425 and the fifth time 430 to decrease the capacitor voltage 405 to be approximately equal to the reference potential. At the fifth time 430, the capacitor 220 supplies current to the common potential through the inductor 230.

At a sixth time 435, the capacitor 220 stops supplying current to the inductor 230 in response to the capacitor voltage 405 being approximately equal to common potential. At the sixth time 435, the inductor 230 gradually reduces the current being supplied to the common potential from the capacitor 220, which continues to discharge the capacitor 220 to a voltage less than the common potential.

Such charging and discharging of the capacitor 220 by the inductor 230 causes the capacitor voltage 405 to oscillate over time, until the voltage across the capacitor 220 has settled. Such an oscillation may be referred to as a dampening sinusoidal waveform.

FIG. 4B is a timing diagram 440 of an example operation of the first implementation of the first detection circuitry 115A of FIGS. 1 and 2. In the example of FIG. 4B, the timing diagram 440 illustrates a detection output (Detect$_{OUT}$) 445 over time. The detection output 445 represents the voltage at the detection output of the first detection circuitry 115A following the controller circuitry 120 of FIGS. 1-3 supplying a voltage pulse to the first detection circuitry 115A.

At a seventh time 450, the detection output 445 transitions from a logic high (HI) to a logic low (LOW), representing the capacitor voltage 405 of FIG. 4A being equal to the reference potential. The seventh time 450 corresponds to the second time 415 of FIG. 4A.

At an eighth time 455, the detection output 445 remains a logic low, representing the capacitor voltage 405 remaining below the reference potential. The eighth time 455 corresponds to the third time 420 of FIG. 4A.

At a ninth time 460, the detection output 445 transitions from a logic low to a logic high, representing the capacitor voltage 405 being equal to the reference potential. The ninth time 460 corresponds to the fourth time 425.

At a tenth time 465, the detection output 445 remains a logic high, representing the capacitor voltage 405 remaining above the reference potential. The tenth time 465 corresponds to the fifth time 430 of FIG. 4A.

At an eleventh time 470, the detection output 445 transitions from a logic high to a logic low, representing the capacitor voltage 405 being equal to the reference potential. The eleventh time 470 corresponds to the sixth time 435 of FIG. 4A.

The controller circuitry 120 of FIGS. 1-3 determines whether a connector is approaching the device 110 based on the time between the ninth time 460 and the eleventh time 470. For example, the counter circuitry 390 of FIG. 3 counts a number of cycles of a reference clock between the ninth time 460 and the eleventh time 470. Variations in the reference count generated by counter circuitry 390 enable the comparison circuitry 340 of FIG. 3 to differentiate between types of connectors.

FIG. 5 is a schematic diagram of an example device 500 including a second example of the detection circuitry 115A-115D of FIG. 1 and a second example of the controller circuitry 120 of FIG. 1. In the example of FIG. 5, the device 500 includes the indicator 125 of FIGS. 1 and 2, the charger port 130 of FIGS. 1 and 2, example detection circuitry 510, and example controller circuitry 520.

The indicator 125 is electrically coupled to the controller circuitry 520. The indicator 125 generates a perceivable indication based on the first indication and/or the second indication from the controller circuitry 520. For example, the indicator 125 illuminates a green LED when the controller circuitry 520 determines that a connector is approaching a compatible port. In such an example, the indicator illuminates a red LED to indicate that the connector is approaching an incompatible port.

The example detection circuitry 510 is electrically coupled to the controller circuitry 520. The example detection circuitry 510 is configured to be placed in an device package in proximity to the charger port 130, such that a connector approaching the charger port 130 enters a magnetic field of the detection circuitry 510. The example detection circuitry 510 may be placed in proximity to one or more ports, such as the ports 135-160 of FIG. 1.

In the example of FIG. 5, the detection circuitry 510 includes an example transistor 530, an example inductor 540, an example voltage source 550, an example diode 560, an example capacitor 570, and an example resistor 580. The detection circuitry 510 is configured to modify a voltage across the capacitor 570 as an inductance of the inductor 540 varies. In the example of FIG. 5, an approaching connector causes reverse electromotive force (EMF) in the detection circuitry 510. The EMF modifies current flowing through the inductor 540 which causes the voltage across the capacitor 570 to increase.

The transistor 530 is electrically coupled to the controller circuitry 520, the inductor 540, the diode 560, and a common potential (e.g., ground). The controller circuitry 520 controls the transistor 530 by a voltage pulse input ($V_{IN}$). The controller circuitry 520 may turn on (e.g., conducting) the transistor 530 and turn off (e.g., non-conducting) the transistor 530. The transistor 530 is a P-channel metal oxide semiconductor field effect transistor (MOSFET). Alternatively, the transistor 530 may be a PNP bipolar junction transistor (BJT), an N-channel field-effect transistor (FET), an N-channel insulated-gate bipolar transistor (IGBT), an N-channel junction field effect transistor (JFET), an N-channel MOSFET, a P-channel FET, a P-channel IGBT, a P-channel JFET, or an NPN BJT.

The transistor 530 couples the inductor 540 and the diode 560 to common potential when turned on by the controller circuitry 520. The transistor 530 prevents current from flowing through the inductor 540 to the common potential when turned off by the controller circuitry 520.

The inductor 540 is electrically coupled to the transistor 530, the voltage source 550, and the diode 560. The inductor 540 includes an inductance. The inductor 540 generates a magnetic field based on power supplied by the voltage source 550 and the inductance. A reverse EMF may be induced in the inductor 540 by metal entering a varying magnetic field. The induced reverse EMF results in a voltage difference across the inductor 540 that increases the voltage across the capacitor 570. A magnitude of the voltage induced by reverse EMF is based on an amount of metal, comprising a connector, entering the magnetic field. The inductor 540 is placed in proximity to the charger port 130, such that a connector approaching the port 130 enters the magnetic field generated by the inductor 540.

The voltage source 550 is electrically coupled between the inductor 540 and the common potential. The voltage source 550 is configured to supply a reference voltage to the inductor 540.

The inductor 540 supplies the transistor 530 and the diode 560 with a voltage approximately equal to the reference voltage from the voltage source 550 when the magnetic field is unaffected by a connector. The inductor 540 supplies the transistor 530 and the diode 560 with a modified reference voltage when a connector causes variations in the magnetic field which results in a change in reverse EMF. The modified voltage reference is approximately equal to the reference voltage from the voltage source 550 plus the voltage induced across the inductor 540 by reverse EMF. Such modifications to the reference voltage, induced by variations in the magnetic field, may be referred to as back EMF.

The diode 560 is electrically coupled to the controller circuitry 520, the transistor 530, the inductor 540, the capacitor 570, and the resistor 580. The diode 560 is configured to allow current to flow from the inductor 540 to the controller circuitry 520, the capacitor 570, and/or the resistor 580. The diode 560 is configured to prevent current from flowing from the controller circuitry 520, the capacitor 570, and/or the resistor 580 to the transistor 530 and/or the inductor 540. The diode 560 supplies current to charge the capacitor 570 when the transistor 530 is turned off.

The capacitor 570 is electrically coupled to the controller circuitry 520, the diode 560, the resistor 580, and the common potential. The capacitor 570 is configured to charge while the transistor 530 is turned off. The capacitor 570 is configured discharge by supplying current to the resistor 580. A voltage across the capacitor 570 increases to be approximately equal to the voltage supplied by the voltage source 550 plus the voltage induced by reverse EMF in the inductor 540. The capacitor 570 includes a capacitance configured to filter relatively high frequency noise. For example, the capacitor 570 averages noise induced in the inductor 540 by communications or power transmissions through the port 130. The voltage across the capacitor 570 is supplied to the controller circuitry 520.

The resistor 580 is coupled in parallel to the capacitor 570. The resistor 580 includes a resistance. The resistance of the resistor 580 may be determined to reduce a rate of discharge of the capacitor 570. For example, a relatively large resistance reduces the rate at which the voltage across the capacitor 570 decreases, while a relatively low resistance increases the rate at which the voltage across the capacitor 570 decreases. The resistance of the resistor 580 may be selected to reduce the rate at which the voltage of the detection output changes.

In an example operation of the device 500, the controller circuitry 520 generates a voltage pulse to determine whether a connector is in proximity to the inductor 540. Further, the controller circuitry 520 may generate a pulse width modulation (PWM) signal to generate a plurality of voltage pulses. The controller circuitry 520 supplies the voltage pulse(s) to the voltage pulse input. The inductor 540 generates a varying magnetic field in response to enabling and disabling the transistor 530. A magnitude of a voltage across the inductor 540 is induced by changes in reverse EMF when metal comprising a connector enters such a varying magnetic field.

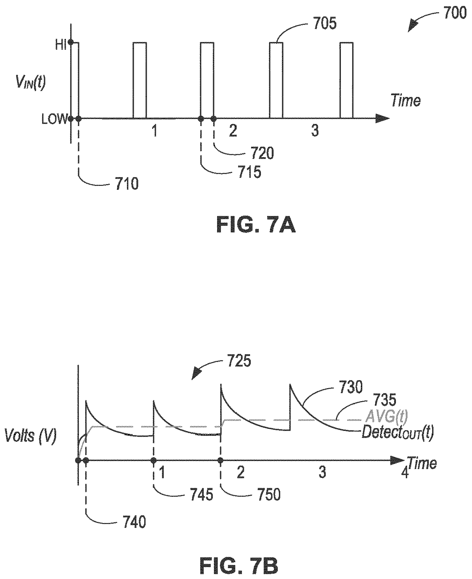

The voltage pulse(s) disables the transistor 530 which begins to charge the capacitor 570 using a voltage supplied by the inductor 540. Following disabling the transistor 530, the inductor 540 charges the capacitor 570 through the diode 560. The inductor 540 charges the capacitor 570 to approximately the reference voltage of the voltage source 550 when a connector is not approaching the port 130. The inductor 540 charges the capacitor 570 to the modified reference voltage when a connector is approaching the port 130. The modified reference voltage being the reference voltage of the voltage source 550 plus any voltage induced in the example inductor 540 by reverse EMF. A magnitude of the reverse EMF induced in the example inductor 540 differs based on the type of connector approaching the port 130. An example operation of the detection circuitry 510 is illustrated and discussed in connection with FIGS. 7A and 7B.

The controller circuitry 520 enables the transistor 530 to couple the inductor 540 and the diode 560 to the common potential. Following the controller circuitry 520 enabling the transistor 530, the capacitor 570 begins to discharge to a voltage below the reference voltage. The capacitor 570 discharges at a rate based on the resistor 580. The controller circuitry 520 determines whether a connector is in proximity to the inductor 540 based on variations in the voltage across the capacitor 570 from the reference voltage.

In the example of FIG. 5, the controller circuitry 520 is electrically coupled to the indicator 125 and the detection circuitry 510. The controller circuitry 520 is configured to determine whether a connector (e.g., the connector 105 of FIG. 1) is in proximity to the detection circuitry 510, which corresponds to the charger port 130. The controller circuitry 520 initiates a detection output $(Detect_{OUT})$ of the detection circuitry 510 by supplying a voltage pulse to a voltage pulse input $(V_{IN})$ of the detection circuitry 510. The controller circuitry 520 determines the type of connector based on a magnitude of variations in the detection output of the detection circuitry 510 following the voltage pulse.

The controller circuitry 520 generates a first indication in response to determining the type of connector is compatible with the charger port 130. The controller circuitry 520 generates a second indication in response to determining the type of connector is incompatible with the charger port 130. The controller circuitry 520 supplies the first indication and the second indication to the indicator 125.

FIG. 6 is a block diagram of the controller circuitry 520 of FIG. 5. The example of the controller circuitry 520 may be instantiated (e.g., creating an instance of, bring into being for any length of time, materialize, implement, etc.) by processor circuitry such as a central processing unit executing instructions. Additionally or alternatively, the controller circuitry 520 of FIG. 5 may be instantiated (e.g., creating an instance of, bring into being for any length of time, materialize, implement, etc.) by an ASIC or an FPGA structured to perform operations corresponding to the instructions. It should be understood that some or all of the circuitry of FIG. 6 may, thus, be instantiated at the same or different times. Some or all of the circuitry may be instantiated, for example, in one or more threads executing concurrently on hardware and/or in series on hardware. Moreover, in some examples, some or all of the circuitry of FIG. 6 may be implemented by microprocessor circuitry executing instructions to implement one or more virtual machines and/or containers.

In the example of FIG. 6, the controller circuitry 520 includes a first example voltage monitor 610, a second example voltage monitor 620, a third example voltage monitor 630, an example comparison circuitry 640, and an example memory 650. The controller circuitry 520 is configured to be coupled to one or more of the detection circuitry 510 of FIG. 5. Although in the example of FIG. 6 the controller circuitry 520 includes the voltage monitors 610-630, the controller circuitry 520 may be modified to include a plurality of the voltage monitors 610-630 configured to be coupled to one or more instances of the detection circuitry 510.

The first voltage monitor 610 is configured to be coupled to one or more instances of the detection circuitry 510. In the example of FIG. 6, the first voltage monitor 610 includes example timer circuitry 660, an example pulse generator circuitry 670, and example analog-to-digital converter (ADC) circuitry 680. The first voltage monitor 610 generates a voltage pulse to initiate the detection output of the detection circuitry 510. The first voltage monitor 610 determines a voltage of the detection output following a voltage pulse. Alternatively, the period detector 310 may be configured to determine an average voltage of the detection output between a plurality of voltage pulses.

The timer circuitry 660 is coupled to the pulse generator circuitry 670 and the ADC circuitry 680. The timer circuitry 660 generates a reference clock of a predetermined frequency. The timer circuitry 660 may be a resistor-capacitor (RC) clock, a crystal oscillator, a voltage controlled oscillator, etc. The timer circuitry 660 supplies the reference clock to the pulse generator circuitry 670. In some examples, the timer circuitry 660 is instantiated by processor circuitry executing timing instructions and/or configured to perform operations such as those represented by the flowchart of FIG. 10.

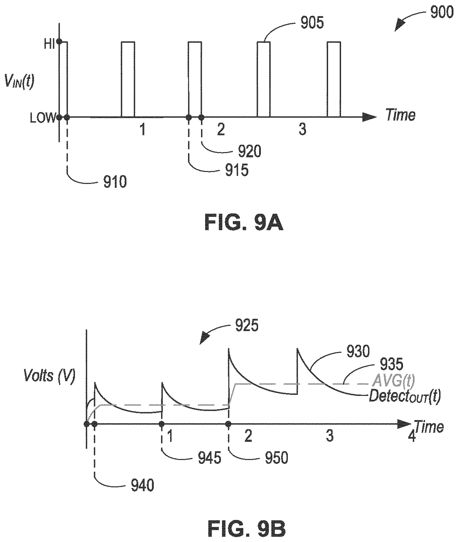

The pulse generator circuitry 670 is configured to be coupled to one or more instances of the detection circuitry 510 and the timer circuitry 660. The pulse generator circuitry 670 generates a voltage pulse. The pulse generator circuitry 670 may generate a pulse width modulation (PWM) signal as a chain of sequential voltage pulses of a duration corresponding to a duty cycle. The pulse generator circuitry 670 supplies the voltage pulse to at least one instance of the detection circuitry 510 by the voltage pulse input ($V_{IN}$). An example output of the pulse generator circuitry 670 is illustrated in connection with FIGS. 7A and 9A. In some examples, the pulse generator circuitry 670 is instantiated by processor circuitry executing generation instructions and/or configured to perform operations such as those represented by the flowchart of FIGS. 10 and 11.

The ADC circuitry 680 is configured to be coupled to the detection circuitry 510, the comparison circuitry 640, and the timer circuitry 660. The ADC circuitry 680 converts an analog voltage of the detection output to a digital value which represents the analog voltage. The ADC circuitry 680 supplies the digital value to the comparison circuitry 640. In some examples, the ADC circuitry 680 is instantiated by processor circuitry executing counter instructions and/or configured to perform operations such as those represented by the flowchart of FIGS. 10 and 11.

Although the first voltage monitor 610 is illustrated in FIG. 6, the controller circuitry 520 may include one or more instances of the first voltage monitor 610 coupled to one or more instances of the detection circuitry 510. The voltage monitors 620 and 630 include circuitry substantially similar to the first voltage monitor 610.

The comparison circuitry 640 is configured to be coupled to the indicator 125, the voltage monitors 610-530, the memory 650, and the ADC circuitry 680. The comparison circuitry 640 determines whether a connector is approaching the device 500 based on the digital value from the ADC circuitry 680. For example, the comparison circuitry 640 determines a connector is approaching when the digital value is less than a first threshold value or greater than a second threshold value. In such an example, the threshold values are stored in the memory 650 and may be determined at a time of manufacture, as a result of calibrations, and/or during run-time operations of the device 500. The comparison circuitry 640 generates a first indication when the comparator determines a connector is approaching the device 500.

The comparison circuitry 640 determines a type of the connector based on the digital value from one of the voltage monitors 610-530 and reference values in the memory 650. The comparison circuitry 640 selects the type of a connector by determining a voltage range corresponding to a type of connector containing the digital value determined by the ADC circuitry 680. For example, the comparison circuitry 340 may determine the connector is a USB type-A cable when the digital value represents thirty-five millivolts (mV) and the voltage range corresponding to USB type-A cables is voltages between twenty-five millivolts (mV) and forty millivolts (mV).

The comparison circuitry 640 determines if a port corresponding to the detection circuitry 510 used to generate the digital value is a compatible port by comparing a type of the port to the determined type of the connector. The comparison circuitry 640 generates a second indication representative of a determination that the type of port is incompatible with the type of connector. The comparison circuitry 640 generates a third indication representative of a determination that the type of port is compatible with the type of connector. In some examples, the comparison circuitry 640 is instantiated by processor circuitry executing comparison instructions and/or configured to perform operations such as those represented by the flowchart of FIGS. 10 and 11.

The memory 650 is coupled to the comparison circuitry 640. The memory 650 stores a plurality of intervals corresponding to types of connectors and data representing which instance of the detection circuitry 510 corresponds to which type of port. For example, the memory 650 stores a look-up table including a plurality of connector types linked to intervals of which the reference count corresponds to that type of connector. In another example, the memory 650 stores a look-up table including data indicating a type of port for each of the ports in proximity to each instance of the detection circuitry 510. The memory 650 include intervals which have been set by a manufacturer, calibrated, determined by the device 110, etc. The memory 650 allows the comparison circuitry 640 to access interval data and port type data. In some examples, the memory 650 is instantiated by processor circuitry executing storage instructions and/or configured to perform operations such as those represented by the flowchart of FIGS. 10 and 11.

Although in the example of FIG. 6 the controller circuitry 520 was discussed in connection with the detection circuitry 510, the controller circuitry 520 may be configured to detect an approaching connector to detection circuitry configured to modify a voltage in response to a connector. For example, the controller circuitry 520 may be coupled to a Hall effect sensor configured to be in proximity to the charger port 130, similar to the detection circuitry 510. Another example is illustrated in connection with FIG. 8, below.

FIG. 7A and 7B is a timing diagram of an example operation of the detection circuitry 510 of FIG. 5. FIG. 7A is a timing diagram 700 of an example operation of the controller circuitry 520 of FIGS. 5 and 6. In the example of FIG. 7A, the timing diagram 700 illustrates an example voltage pulse input ($V_{IN}$) 705 over time. The voltage pulse input 705 represents the voltage of the voltage pulse input of the detection circuitry 510 as generated by the pulse generator circuitry 670 of FIG. 6.

At a first time 710, the voltage pulse input 705 transitions from a logic high (HI) to a logic low (LOW), representing a falling edge of a voltage pulse from the pulse generator circuitry 670. At the first time 710, the voltage pulse input 705 enables the transistor 530 of FIG. 5. Alternatively, the voltage pulse input 705 may be inverted to represent operations of the pulse generator circuitry 670 when the transistor 530 is a N-channel MOSFET, NPN BJT, etc. At times following the first time 710, the capacitor 570 of FIG. 5 begins to discharge by supplying current through the resistor 580 of FIG. 5.

At a second time 715, the voltage pulse input 705 transitions from a logic low to a logic high, representing a rising edge of a voltage pulse from the pulse generator circuitry 670. At the second time 715, the voltage pulse input 705 disables the transistor 530. At the second time 715, the voltage source 550 of FIG. 5 supplies a current to the inductor 540 of FIG. 5. At times immediately following the second time 715, the inductor 540 generates a varying magnetic field as the current flowing through the inductor 540 varies as the inductor 540 charges. Following the second time 715 and before a falling edge, an approaching connector causes a voltage difference across the example inductor 540 as a result of reverse EMF.

At a third time 720, the voltage pulse input 705 transitions from a logic high to a logic low, representing a falling edge of a voltage pulse from the pulse generator circuitry 670. At the third time 720, the voltage pulse input 705 enables the transistor 530. At times following the first time 710, the capacitor 570 begins to discharge by supplying current through the resistor 580.

FIG. 7B is a timing diagram 725 of an example operation of the detection circuitry 510 of FIG. 5. In the example of FIG. 7B, the timing diagram 725 illustrates a detection output ($Detect_{OUT}$) 730 and an average voltage (AVG) 735 over time. The detection output 730 represents the voltage at the detection output of the detection circuitry 510 during the example operation of the voltage pulse input 705 of FIG. 7A. The average voltage 735 represents an average voltage of the detection output 730 over time.

At a fourth time 740, the detection output 730 increases to a local maximum voltage in response to the transistor 530 being disabled by the falling edge of the voltage pulse input 705 of FIG. 7A at the first time 710 of FIG. 7A. The local maximum voltage corresponds to the reference voltage of the voltage source 550 of FIG. 5 plus a voltage difference across the inductor 540 induced by reverse EMF. Following the fourth time 740, the detection output 730 decreases, similar to a voltage decay of a resistor-capacitor (RC) circuit. The rate of voltage decrease of the detection output 730 may be increased by decreasing the resistance of the resistor 580. The rate of voltage decrease of the detection output 730 may be decreased by increasing the resistance of the resistor 580.

At a fifth time 745, the detection output 730 increases to a local maximum voltage in response to the transistor 530 being disabled by the falling edge of the voltage pulse input 705. The local maximum voltage corresponds to the reference voltage of the voltage source 550 plus a voltage difference across the inductor 540 induced by reverse EMF at the fifth time 745. At the fifth time 745, the controller circuitry 520 of FIG. 5 determines whether a connector caused reverse EMF in the inductor 540 by comparing the local maximum voltage to threshold values. Following the fifth time 745, the controller circuitry 520 determines the type of connector by comparing the local maximum voltage to voltage ranges stored in the memory 650 of FIG. 6.

Alternatively, the controller circuitry 520 may be configured to determine the average voltage 735 of the detection output 730 between the fourth time 740 and the fifth time 745. In such an example, the controller circuitry 520 may determine whether a connector is in proximity to the detection circuitry 510 by comparing the average voltage 735 to threshold values.

At a sixth time 750, the detection output 730 increases to a local maximum voltage in response to the transistor 530 being disabled by a falling edge of the voltage pulse input 705 at the third time 720. The local maximum voltage at the sixth time 750 is greater than the local maximum voltage at the fifth time 745. The controller circuitry 520 determines such differences between local maximum voltages to be variations in reverse EMF corresponding to variations in voltage differences across the inductor 540. The difference between local maximum voltages may indicate a different connector is present at the sixth time 750 or a connector is not present at the fifth time 745 but is present at the sixth time 750. The controller circuitry 520 may determine the type of connector by comparing the local maximum voltage at the fifth time 745 to the local maximum voltage at the sixth time 750. At the sixth time 750, the average voltage 735 increases following the increase in the local maximum voltage.

FIG. 8 is a schematic diagram of an example device 800 including a third example implementation of the detection circuitry 115A-115D of FIG. 1. In the example of FIG. 8, the device 800 includes the indicator 125 of FIGS. 1, 2, and 5, the charger port 130 of FIGS. 1, 2, and 5, the controller circuitry 520 of FIGS. 5 and 6, and example detection circuitry 810.

In the example of FIG. 8, the controller circuitry 520 is electrically coupled to the indicator 125 and the detection circuitry 810. The controller circuitry 520 is configured to determine whether a connector (e.g., the connector 105 of FIG. 1) is in proximity to the detection circuitry 810, which corresponds to the charger port 130. The controller circuitry 520 initiates a detection output (Detect$_{OUT}$) of the detection circuitry 810 by supplying a voltage pulse to a voltage pulse input ($V_{IN}$) of the detection circuitry 810. The controller circuitry 520 determines the type of connector based on variations in the detection output of the detection circuitry 810 following the voltage pulse.

The controller circuitry 520 generates a first indication in response to determining the type of connector is compatible with the charger port 130. The controller circuitry 520 generates a second indication in response to determining the type of connector is incompatible with the charger port 130. The controller circuitry 520 supplies the first indication and the second indication to the indicator 125.

The indicator 125 is electrically coupled to the controller circuitry 520. The indicator 125 generates a perceivable indication based on the first indication and/or the second indication from the controller circuitry 520. For example, the indicator 125 illuminates a green LED when the controller circuitry 520 determines that a connector is approaching a compatible port. In such an example, the indicator illuminates a red LED to indicate that the connector is approaching an incompatible port.

The detection circuitry 810 is electrically coupled to the controller circuitry 520. The detection circuitry 810 is configured to be placed in an device package in proximity to the charger port 130. The detection circuitry 810 may be placed in proximity to one or more ports, such as the ports 135-160 of FIG. 1.

In the example of FIG. 8, the detection circuitry 810 includes an example transistor 820, a first example diode 830, a first example inductor 840, an example voltage source 850, a second example inductor 860, a second example diode 870, an example capacitor 880, and an example resistor 890. The detection circuitry 810 is configured to modify a voltage across the capacitor 880 based on a current induced in the second inductor 860 by the first inductor 840. In the example of FIG. 8, the current induced in the second inductor 860 by the first inductor 840 varies when a connector approaches the port 130. Such variations are a result of the first inductor 840 inducing eddy currents in metal comprising a connector, which allows the inductors 840 and 860 to magnetically couple. Such eddy currents are a result of a diamagnetic material comprising the connector. Alternatively, inductive or magnetic coupling, which impact the detection circuitry similar to eddy currents, may result from paramagnetic and/or ferromagnetic materials.

The transistor 820 is electrically coupled to the controller circuitry 520, the first diode 830, the first inductor 840, and a common potential (e.g., ground). The controller circuitry 520 controls the transistor 820 by a voltage pulse input ($V_{IN}$). The controller circuitry 520 may turn on (e.g., conducting) the transistor 820 and turn off (e.g., non-conducting) the transistor 820. The transistor 820 is a P-channel MOSFET. Alternatively, the transistor 820 may be a PNP BJT, an N-channel FET, an N-channel IGBT, an N-channel JFET, an N-channel MOSFET, a P-channel FET, a P-channel IGBT, a P-channel JFET, or an NPN BJT.

The transistor 820 couples the first diode 830 and the first inductor 840 to the common potential when turned on by the controller circuitry 520. The transistor 820 prevents current from flowing through the transistor 820 to the common potential when turned off by the controller circuitry 520.

The first diode 830 is electrically coupled to the transistor 820, the first inductor 840, and the voltage source 850. The first diode 830 is coupled in parallel to the first inductor 840. The first diode 830 allows current to flow through the first inductor 840 more than once when the transistor 820 is disabled and there is a voltage drop across the first inductor 840. The first diode 830 prevents current from flowing through the first inductor 840 more than once when the transistor 820 is enabled or there is no voltage drop across the first inductor 840.

The first inductor 840 is electrically coupled to the transistor 820, the first diode 830, and the voltage source 850. The first inductor 840 is configured to be magnetically coupled to the second inductor 860 when metal comprising a connector enters a varying magnetic field of the first inductor 840. The first inductor 840 includes a first inductance. The first inductor 840 is configured to induce a current in the second inductor 860 by generating a magnetic field. The first inductor 840 is configured to generate the magnetic field based on power supplied by the voltage source 850, the first inductance, and the second inductor 860. The controller circuitry 520 generates a varying magnetic field in the first inductor 840 by enabling and disabling the transistor 820.

The first inductor 840 may induce eddy currents in metal comprising a connector, when the connector enters a varying magnetic field between the first inductor 840 and the second inductor 860. An eddy current is a current induced in a conductive surface by variations in a magnetic field. For example, eddy currents are induced in metal comprising a connector while the first inductor 840 generates a magnetic field following the transistor 820 being disabled. In such an example, as the first inductor 840 generates a varying magnetic field as current flowing through the first inductor 840 begins to settle. A magnitude of eddy currents being generated by the first inductor 840 varies based on an amount of metal comprising a connector. A type of a connector, approaching the port 130, may be determined based on effects of the magnitude of eddy currents being generated on the current being induced in the second inductor 860.

The voltage source 850 is electrically coupled to the first diode 830, the first inductor 840, and the common potential. The example voltage source 850 is configured to supply a reference voltage to the first diode 830 and the first inductor 840.

The second inductor 860 is electrically coupled between the second diode 870 and the common potential. The second inductor 860 is configured to be magnetically coupled to the first inductor 840, when metal comprising a connector enters a magnetic field of the first inductor 840. The second inductor 860 includes a second inductance. The second inductor 860 is configured to generate a current by capturing the magnetic field generated by the first inductor 840. The second inductor 860 supplies a current, induced by the first inductor 840, to the second diode 870.

The second diode 870 is electrically coupled to the controller circuitry 520, the second inductor 860, the capacitor 880, and the resistor 890. The second diode 870 allows current to flow from the second inductor 860 to the controller circuitry 520, the capacitor 880, and/or the resistor 890. The second diode 870 is configured to prevent current from flowing from the controller circuitry 520, the capacitor 880, and/or the resistor 890 to the second inductor 860. The second diode 870 supplies current induced in the second inductor 860 to the capacitor 880 and the resistor 890.

The capacitor 880 is electrically coupled to the controller circuitry 520, the second diode 870, the resistor 890, and the common potential. A voltage across the capacitor 880 is based on the current induced in the second inductor 860 and the resistor 890. For example, the second inductor 860 charges the capacitor 880 using current caused by variations in eddy currents being generated. The voltage across the capacitor 880 is supplied to the controller circuitry 520 and/or the resistor 890.

The capacitor 880 includes a capacitance configured to filter relatively high frequency noise. For example, the capacitor 880 averages noise induced in the second inductor 860 by communications or power transmissions through the port 130.

The resistor 890 is electrically coupled to the controller circuitry 520, the second diode 870, and the capacitor 880. The resistor 890 is coupled in parallel to the capacitor 880. The resistor 890 includes a resistance. The resistance of the resistor 890 may be determined to reduce a rate of discharge of the capacitor 880. For example, a relatively large resistance reduces the rate at which the voltage across the capacitor 880 decreases, while a relatively low resistance increases the rate at which the voltage across the capacitor 880 decreases. The resistance of the resistor 890 may be selected to reduce the rate at which the voltage of the detection output changes.

In an example operation of the device 800, the controller circuitry 520 generates a voltage pulse to determine whether a connector is in proximity to the inductors 840 and/or 860. Further, the controller circuitry 520 may generate a pulse width modulation (PWM) signal to generate a plurality of voltage pulses. The controller circuitry 520 supplies the voltage pulse(s) to the voltage pulse input.

The voltage pulse(s) disable and enable the transistor 820 to allow the first inductor 840 to generate a varying magnetic field of enough of a magnitude to induce current in the second inductor 860. Following disabling the transistor 820, the first inductor 840 begins to generate the varying magnetic field. The first inductor 840 induces a current in the second inductor 860 of a first magnitude when a connector is not approaching the port 130. The first inductor 840 induces eddy currents in metal comprising a connector when the connector enters the varying magnetic field being generated by the first inductor 840. The first inductor 840 induces a current in the second inductor 860 of a second magnitude when a connector is approaching the port 130. The eddy currents being induced in the connector result in the second magnitude of current being induced in the second inductor 860 being substantially larger than the first magnitude.

The second inductor 860 supplies a current to the second diode 870 based on the magnetic field of the first inductor 840 and the eddy currents being induced. The second diode 870 supplies the current induced in the second inductor 860 to the capacitor 880. The induced current charges the capacitor 880. A voltage across the capacitor 880 is based on the magnitude of current induced in the second inductor 860. The voltage of the capacitor 880 varies based on the amount of eddy currents being induced in metal comprising a connector.

The controller circuitry 520 measures the voltage across the capacitor 880 to determine whether a connector is in proximity to the charger port 130. The controller circuitry 520 determines a type of connector based on a difference between the voltage across the capacitor 880 when a connector is not approaching the device 800 and a measured voltage. An example operation of the controller circuitry 520 in the example of being coupled to the detection circuitry 810 is illustrated in connection with FIGS. 9A and 9B.

FIG. 9A and 9B is a timing diagram of an example operation of the detection circuitry 810 of FIG. 8. FIG. 9A is a timing diagram 900 of an example operation of the controller circuitry 520 of FIGS. 5, 6, and 8. In the example of FIG. 9A, the timing diagram 900 illustrates an example voltage pulse input ($V_{IN}$) 905 over time. The voltage pulse input 905 represents the voltage of the voltage pulse input of the detection circuitry 810 as generated by the pulse generator circuitry 670 of FIG. 6.

At a first time 910, the voltage pulse input 905 transitions from a logic high (HI) to a logic low (LOW), representing a falling edge of a voltage pulse from the pulse generator circuitry 670. At the first time 910, the voltage pulse input 905 enables the transistor 820 of FIG. 8. Alternatively, the voltage pulse input 905 may be inverted to represent operations of the pulse generator circuitry 670 when the transistor 820 is a N-channel MOSFET, NPN BJT, etc. At times following the first time 910, the capacitor 880 of FIG. 8 begins to discharge by supplying current through the resistor 890 of FIG. 8.

At a second time 915, the voltage pulse input 905 transitions from a logic low to a logic high, representing a rising edge of a voltage pulse from the pulse generator circuitry 670. At the second time 915, the voltage pulse input 905 disables the transistor 820. At the second time 915, the example voltage source 850 of FIG. 8 supplies a current to the first inductor 840 of FIG. 8. At times immediately following the second time 915, the first inductor 840 generates a varying magnetic field as the current flowing through the first inductor 840 varies as the first inductor 840 charges. Following the second time 915 and before a falling edge, eddy currents generated in an approaching connector, by the magnetic field of the first inductor 840, increases current induced in the second inductor 860 by the magnetic field of the first inductor 840.

At a third time 920, the voltage pulse input 905 transitions from a logic high to a logic low, representing a falling edge of a voltage pulse from the pulse generator circuitry 670. At the third time 920, the voltage pulse input 905 enables the transistor 820. At times following the first time 910 and prior to a following rising edge, the capacitor 880 begins to discharge by supplying current through the resistor 890.

FIG. 9B is a timing diagram 925 of an example operation of the detection circuitry 810 of FIG. 8. In the example of FIG. 9B, the timing diagram 925 illustrates a detection output (Detect$_{OUT}$) 930 and an average voltage (AVG) 935 over time. The detection output 930 represents the voltage at the detection output of the detection circuitry 810 during the example operation of the voltage pulse input 905 of FIG. 9A. The average voltage 935 represents an average voltage of the detection output 930 over time.

At a fourth time 940, the detection output 930 increases to a local maximum voltage in response to the transistor 820 being disabled by the falling edge of the voltage pulse input 905 of FIG. 9A at the first time 910 of FIG. 9A. The local maximum voltage corresponds to a voltage of the capacitor 880. The voltage of the example capacitor 880 corresponds to an amount of current induced in the second inductor 860 by the first inductor 840. Following the fourth time 940, the detection output 930 decreases, similar to a voltage decay of a resistor-capacitor (RC) circuit. The rate of voltage decrease of the detection output 930 may be increased by decreasing the resistance of the resistor 890. The rate of voltage decrease of the detection output 930 may be decreased by increasing the resistance of the resistor 890.

At a fifth time 945, the detection output 930 increases to a local maximum voltage in response to the transistor 820 being disabled by the falling edge of the voltage pulse input 905. At the fifth time 945, the controller circuitry 520 of FIGS. 5, 6, and 8 determines whether a connector caused current to be induced in the second example inductor 860 by comparing the local maximum voltage to threshold values. Following the fifth time 945, the controller circuitry 520 determines the type of connector by comparing the local maximum voltage to voltage ranges stored in the memory 650 of FIG. 6.

Alternatively, the controller circuitry 520 may be configured to determine the average voltage 935 of the detection output 930 between the fourth time 940 and the fifth time 945. In such an example, the controller circuitry 520 may determine whether a connector is in proximity to the detection circuitry 810 by comparing the average voltage 935 to threshold values.

At a sixth time 950, the detection output 930 increases to a local maximum voltage in response to the transistor 820 being disabled by a falling edge of the voltage pulse input 905 at the third time 920 of FIG. 9A. The local maximum voltage at the sixth time 950 is greater than the local maximum voltage at the fifth time 945. The example controller circuitry 520 determines such differences between local maximum voltages to be variations in an amount of current induced in the second inductor 860 by the first inductor 840 and eddy currents in metal comprising a connector. The difference between local maximum voltages may indicate a different connector is present at the sixth time 950 or a connector is not present at the fifth time 945 but is present at the sixth time 950. The controller circuitry 520 may determine the type of connector by comparing the local maximum voltage at the fifth time 945 to the local maximum voltage at the sixth time 950. At the sixth time 950, the average voltage 935 increases following the increase in the local maximum voltage, which enables the average voltage 935 to be used to determine the type of connector.

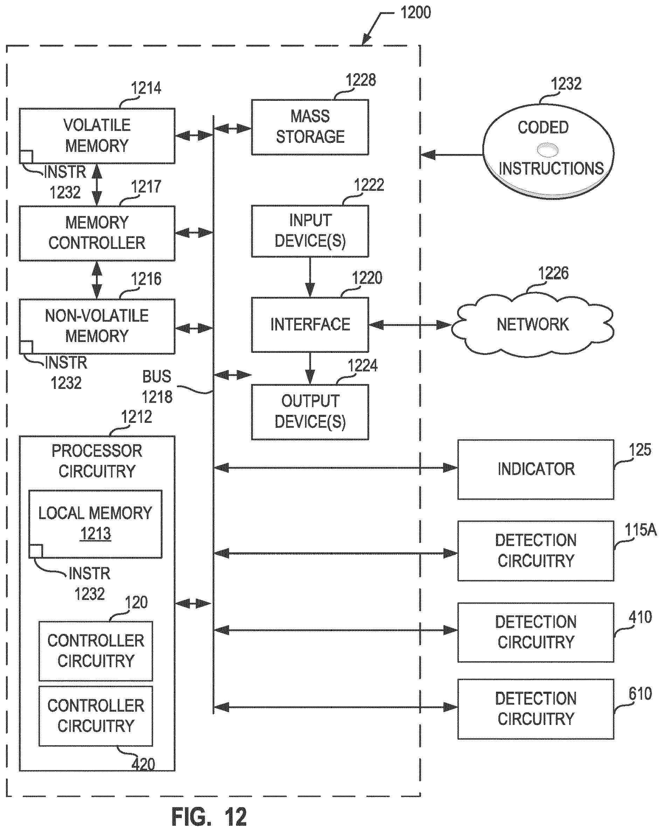

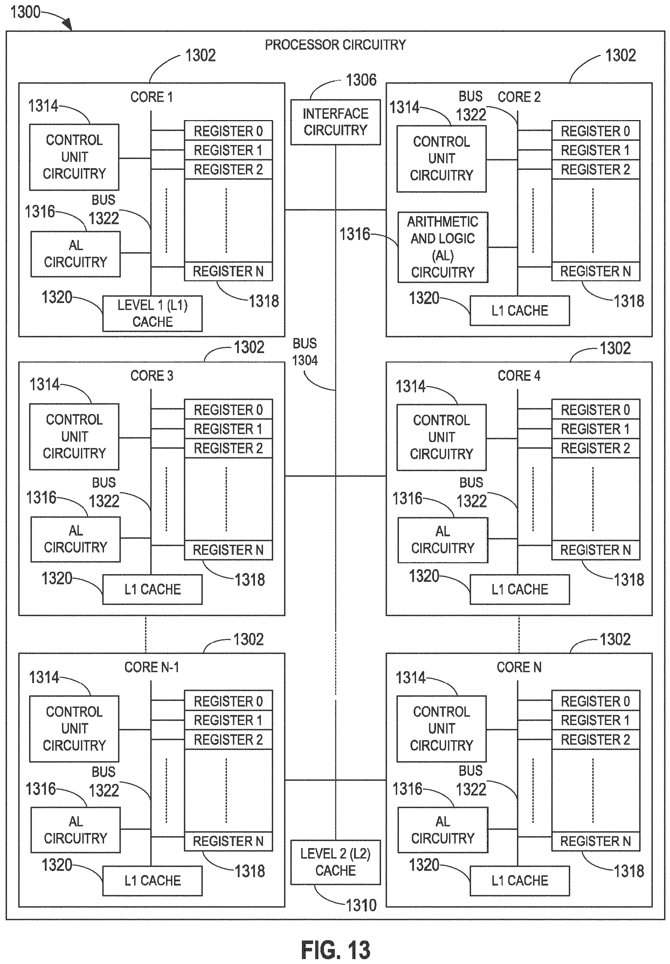

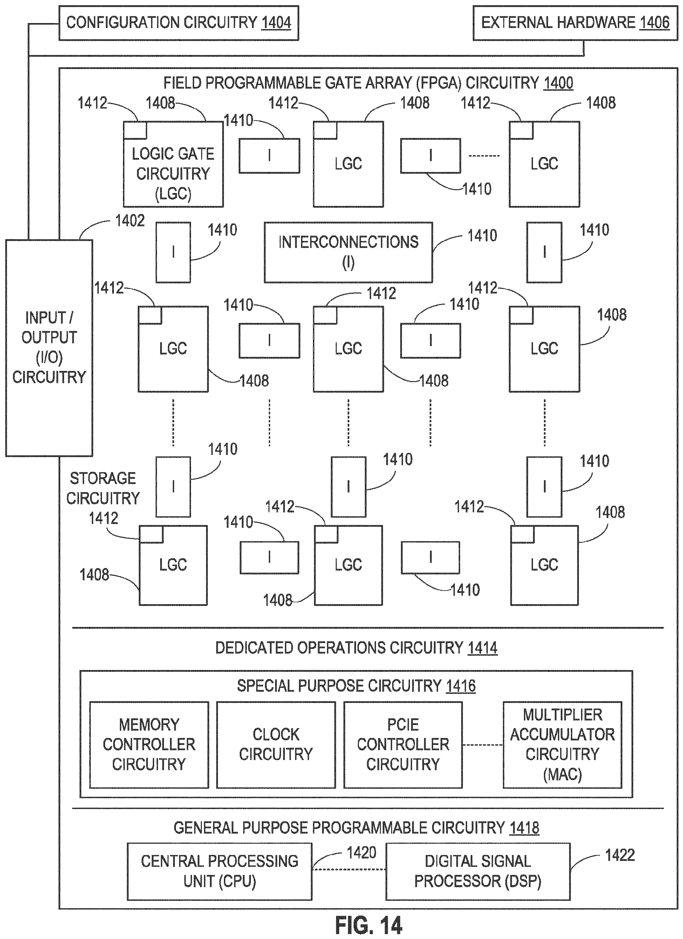

A flowchart representative of example machine readable instructions, which may be executed to configure processor circuitry to implement the device 110 of FIGS. 1 and 2, is shown in FIG. 10. A flowchart representative of example machine readable instructions, which may be executed to configure processor circuitry to implement the device 500 of FIG. 5, is shown in FIG. 11. A flowchart representative of example machine readable instructions, which may be executed to configure processor circuitry to implement the device 800 of FIG. 8, is shown in FIG. 11. The machine readable instructions may be one or more executable programs or portion(s) of an executable program for execution by processor circuitry, such as the processor circuitry 1212 shown in the example processor platform 1200 discussed below in connection with FIG. 12 and/or the example processor circuitry discussed below in connection with FIGS. 13 and/or 14. The program may be embodied in software stored on one or more non-transitory computer readable storage media such as a compact disk (CD), a floppy disk, a hard disk drive (HDD), a solid-state drive (SSD), a digital versatile disk (DVD), a Blu-ray disk, a volatile memory (e.g., Random Access Memory (RAM) of any type, etc.), or a non-volatile memory (e.g., electrically erasable programmable read-only memory (EEPROM), FLASH memory, an HDD, an SSD, etc.) associated with processor circuitry located in one or more hardware devices, but the entire program and/or parts thereof could alternatively be executed by one or more hardware devices other than the processor circuitry and/or embodied in firmware or dedicated hardware. The machine readable instructions may be distributed across multiple hardware devices and/or executed by two or more hardware devices (e.g., a server and a client hardware device). For example, the client hardware device may be implemented by an endpoint client hardware device (e.g., a hardware device associated with a user) or an intermediate client hardware device (e.g., a radio access network (RAN)) gateway that may facilitate communication between a server and an endpoint client hardware device). Similarly, the non-transitory computer readable storage media may include one or more mediums located in one or more hardware devices. Further, although the example program is described with reference to the flowchart illustrated in FIGS. 10 and/or 11, many other methods of implementing the example device 110, the device 500, and/or the device 800 may alternatively be used. For example, the order of execution of the blocks may be changed, and/or some of the blocks described may be changed, eliminated, or combined. Additionally or alternatively, any or all of the blocks may be implemented by one or more hardware circuits (e.g., processor circuitry, discrete and/or integrated analog and/or digital circuitry, an FPGA, an ASIC, a comparator, an operational-amplifier (op-amp), a logic circuit, etc.) structured to perform the corresponding operation without executing software or firmware. The processor circuitry may be distributed in different network locations and/or local to one or more hardware devices (e.g., a single-core processor (e.g., a single core central processor unit (CPU)), a multi-core processor (e.g., a multi-core CPU, an XPU, etc.) in a single machine, multiple processors distributed across multiple servers of a server rack, multiple processors distributed across one or more server racks, a CPU and/or a FPGA located in the same package (e.g., the same integrated circuit (IC) package or in two or more separate housings, etc.).

The machine readable instructions described herein may be stored in one or more of a compressed format, an encrypted format, a fragmented format, a compiled format, an executable format, a packaged format, etc. Machine readable instructions as described herein may be stored as data or a data structure (e.g., as portions of instructions, code, representations of code, etc.) that may be utilized to create, manufacture, and/or produce machine executable instructions. For example, the machine readable instructions may be fragmented and stored on one or more storage devices and/or computing devices (e.g., servers) located at the same or different locations of a network or collection of networks (e.g., in the cloud, in edge devices, etc.). The machine readable instructions may require one or more of installation, modification, adaptation, updating, combining, supplementing, configuring, decryption, decompression, unpacking, distribution, reassignment, compilation, etc., in order to make them directly readable, interpretable, and/or executable by a computing device and/or other machine. For example, the machine readable instructions may be stored in multiple parts, which are individually compressed, encrypted, and/or stored on separate computing devices, wherein the parts when decrypted, decompressed, and/or combined form a set of machine executable instructions that implement one or more operations that may together form a program such as that described herein.

In another example, the machine readable instructions may be stored in a state in which they may be read by processor circuitry, but require addition of a library (e.g., a dynamic link library (DLL)), a software development kit (SDK), an application programming interface (API), etc., in order to execute the machine readable instructions on a particular computing device or other device. In another example, the machine readable instructions may need to be configured (e.g., settings stored, data input, network addresses recorded, etc.) before the machine readable instructions and/or the corresponding program(s) can be executed in whole or in part. Thus, machine readable media, as used herein, may include machine readable instructions and/or program(s) regardless of the particular format or state of the machine readable instructions and/or program(s) when stored or otherwise at rest or in transit.

The machine readable instructions described herein can be represented by any past, present, or future instruction language, scripting language, programming language, etc. For example, the machine readable instructions may be represented using any of the following languages: C, C++, Java, C#, Perl, Python, JavaScript, HyperText Markup Language (HTML), Structured Query Language (SQL), Swift, etc.

As mentioned above, the example operations of FIGS. 10 and/or 11 may be implemented using executable instructions (e.g., computer and/or machine readable instructions) stored on one or more non-transitory computer and/or machine readable media such as optical storage devices, magnetic storage devices, an HDD, a flash memory, a read-only memory (ROM), a CD, a DVD, a cache, a RAM of any type, a register, and/or any other storage device or storage disk in which information is stored for any duration (e.g., for extended time periods, permanently, for brief instances, for temporarily buffering, and/or for caching of the information). As used herein, the terms non-transitory computer readable medium, non-transitory computer readable storage medium, non-transitory machine readable medium, and non-transitory machine readable storage medium are expressly defined to include any type of computer readable storage device and/or storage disk and to exclude propagating signals and to exclude transmission media. As used herein, the terms "computer readable storage device" and "machine readable storage device" are defined to include any physical (mechanical and/or electrical) structure to store information, but to exclude propagating signals and to exclude transmission media. Examples of computer readable storage devices and machine readable storage devices include random access memory of any type, read only memory of any type, solid state memory, flash memory, optical discs, magnetic disks, disk drives, and/or redundant array of independent disks (RAID) systems. As used herein, the term "device" refers to physical structure such as mechanical and/or electrical equipment, hardware, and/or circuitry that may or may not be configured by computer readable instructions, machine readable instructions, etc., and/or manufactured to execute computer readable instructions, machine readable instructions, etc.

"Including" and "comprising" (and all forms and tenses thereof) are used herein to be open ended terms. Thus, whenever a claim employs any form of "include" or "comprise" (e.g., comprises, includes, comprising, including, having, etc.) as a preamble or within a claim recitation of any kind, it is to be understood that additional elements, terms, etc., may be present without falling outside the scope of the corresponding claim or recitation. As used herein, when the phrase "at least" is used as the transition term in, for example, a preamble of a claim, it is open-ended in the same manner as the term "comprising" and "including" are open ended. The term "and/or" when used, for example, in a form such as A, B, and/or C refers to any combination or subset of A, B, C such as (1) A alone, (2) B alone, (3) C alone, (4) A with B, (5) A with C, (6) B with C, or (7) A with B and with C. As used herein in the context of describing structures, components, items, objects and/or things, the phrase "at least one of A and B" is intended to refer to implementations including any of (1) at least one A, (2) at least one B, or (3) at least one A and at least one B. Similarly, as used herein in the context of describing structures, components, items, objects and/or things, the phrase "at least one of A or B" is intended to refer to implementations including any of (1) at least one A, (2) at least one B, or (3) at least one A and at least one B. As used herein in the context of describing the performance or execution of processes, instructions, actions, activities and/or steps, the phrase "at least one of A and B" is intended to refer to implementations including any of (1) at least one A, (2) at least one B, or (3) at least one A and at least one B. Similarly, as used herein in the context of describing the performance or execution of processes, instructions, actions, activities and/or steps, the phrase "at least one of A or B" is intended to refer to implementations including any of (1) at least one A, (2) at least one B, or (3) at least one A and at least one B.

As used herein, singular references (e.g., "a", "an", "first", "second", etc.) do not exclude a plurality. The term "a" or "an" object, as used herein, refers to one or more of that object. The terms "a" (or "an"), "one or more", and "at least one" are used interchangeably herein. Furthermore, although individually listed, a plurality of means, elements or method actions may be implemented by, e.g., the same entity or object. Additionally, although individual features may be included in different examples or claims, these may possibly be combined, and the inclusion in different examples or claims does not imply that a combination of features is not feasible and/or advantageous.

FIG. 10 is a flowchart 1000 representative of example machine readable instructions and/or example operations that may be executed by example processor circuitry to implement the device 110 of FIGS. 1 and 2. The example operations of the flowchart 1000 begin by using the controller circuitry 120 of FIGS. 1-3 to supply a voltage pulse to the detection circuitry 115A-115D. (Block 1010). For example, the pulse generator circuitry 370 of FIG. 3 sets the voltage pulse input ($V_{IN}$) of the first detection circuitry 115A to a logic high for a duration of time. In such an example, the pulse generator circuitry 370 sets the voltage pulse input to a logic low to complete the voltage pulse.

The controller circuitry 120 determines a reference count of the detection output of the detection circuitry 115A-115D between two subsequent edges of the detection output. (Block 1020). For example, the counter circuitry 390 of FIG. 3 generates the reference count by counting a number of cycles of a reference clock between the ninth time 460 of FIG. 4B and the eleventh time 470 of FIG. 4B determined by the edge detection circuitry 380 of FIG. 3. In such an example, the counter circuitry 390 supplies the reference count to the comparison circuitry 340 of FIG. 3.

The controller circuitry 120 determines whether a cable is in proximity of the device 110 by comparing the reference count to threshold values. (Block 1030) For example, the comparison circuitry 340 determines a connector is in proximity to the device 110 when the reference count is less than a maximum count threshold. In such an example, the comparison circuitry 340 determines a connector is in proximity to the device 110 when the reference count is sixty-two while the maximum count threshold is one-hundred and ten. The controller circuitry 120 sends another voltage pulse to the detection circuitry 115-115D when no connector is in proximity to the device 110. (Returns to Block 1010).

The controller circuitry 120 determines a compatible port based on the reference count when the controller circuitry 120 determines a cable is in proximity to the device 110. (Block 1040). For example, the comparison circuitry 340 determines the type of the approaching connector by determining the connector type corresponding to an interval of reference counts, which includes the determined reference count. In such an example, the controller circuitry 120 determines an approaching connector is an HDMI connector when the reference count from the counter circuitry 390 is sixty and reference counts between thirty and sixty-five correspond to HDMI connectors.

The controller circuitry 120 determines whether the cable is near the compatible port by comparing the determined type of connector to the port corresponding to the detection circuitry 115A-115D used to generate the reference count. (Block 1050). For example, the comparison circuitry 340 determines whether the connector is approaching a compatible port by comparing the determined type of the connector to the port corresponding to the detection circuitry used to generate the reference count. In such an example the comparison circuitry 340 determines a charger connector is nearing a compatible port when the charging port 130 of FIGS. 1, 2, 5, and 8, corresponding to the first detection circuitry 115A, is the port the connector is approaching.

The indicator 125 indicates the cable is approaching an incompatible port in response to a first indication from the controller circuitry 120. (Block 1060). For example, the comparison circuitry 340 generates the first indication in response to determining that the connector is an HDMI connector and is approaching the charger port 130. In such an example, the indicator 125 illuminates RED to indicate to the user that the connector is approaching an incompatible port. The controller circuitry 120 sends another voltage pulse to the detection circuitry 115-115D when the connector is in proximity to an incompatible port. (Returns to Block 1010).

The indicator 125 indicates the cable is approaching a compatible port in response to a second indication from the controller circuitry 120. (Block 1070). For example, the comparison circuitry 340 generates the second indication in response to determining that the connector is a charger connector and is approaching the charger port 130. In such an example, the indicator 125 illuminates GREEN to indicate to the user that the connector is approaching a compatible port. The controller circuitry 120 ends the process of flowchart 1000 when the connector is approaching a compatible port.

Although example methods are described with reference to the flowchart 1000 illustrated in FIG. 10, many other methods of detecting whether an approaching connector is near a compatible port may alternatively be used in accordance with this description. For example, the order of execution of the blocks may be changed, and/or some of the blocks described may be changed, eliminated, or combined. Similarly, additional operations may be included in the manufacturing process before, in between, or after the blocks shown in the illustrated examples.

FIG. 11 is a flowchart 1100 representative of example machine readable instructions and/or example operations that may be executed by example processor circuitry to implement the device 500 of FIG. 5 and the device 800 of FIG. 8. The example operations of the flowchart 1100 begin by using the controller circuitry 520 of FIGS. 5, 6, and 8 to supply a voltage pulse to the detection circuitry 510 of FIG. 5 or 810 of FIG. 8. (Block 1110). For example, the pulse generator circuitry 670 of FIG. 6 sets the voltage pulse input ($V_{IN}$) of the detection circuitry 510 to a logic high for a duration of time. In such an example, the pulse generator circuitry 670 sets the voltage pulse input to a logic low to complete the voltage pulse.

The controller circuitry 520 measures a voltage of the detection output of the detection circuitry 510 or 810 between two subsequent edges of the detection output. (Block 1120). For example, the ADC circuitry 680 of FIG. 6 converts the analog voltage of the detection output to a digital value following the falling edges at the times 710 and 720 of FIG. 7A. In such an example, the ADC circuitry 680 supplies the digital value to the comparison circuitry 640 of FIG. 6.

The controller circuitry 520 determines whether a cable is in proximity of the device 110 by comparing the measured voltage to threshold values. (Block 1130) For example, the comparison circuitry 640 determines a connector is in proximity to the device 500 when the digital value represents a voltage greater than a minimum threshold. In such an example, the comparison circuitry 640 determines a connector is in proximity to the device 500 when the digital value represents two-hundred millivolts (mV) while the minimum voltage threshold is one-hundred and fifty millivolts (mV). The controller circuitry 520 sends another voltage pulse to the detection circuitry 510 or 810 when no connector is in proximity to the device 500 or 800. (Returns to Block 1110).

The controller circuitry 520 determines a compatible port based on the voltage of the detection output when the controller circuitry 520 determines a cable is in proximity to the device 500 or 800. (Block 1140). For example, the comparison circuitry 640 determines the type of the approaching connector by determining the connector type corresponding to a voltage range of reference voltages, which includes the measured voltage of the detection output. In such an example, the controller circuitry 520 determines an approaching connector is an HDMI connector when the digital value represents four-hundred millivolts (mV) and the voltages between three-hundred and fifty millivolts (mV) and five-hundred millivolts (mV) correspond to HDMI connectors.

The controller circuitry 520 determines whether the cable is near the compatible port by comparing the determined type of connector to the port corresponding to the detection circuitry 510 or 810 used to measure the voltage. (Block 1150). For example, the comparison circuitry 640 determines whether the connector is approaching a compatible port by comparing the determined type of the connector to the port corresponding to the detection circuitry used to generate the digital value. In such an example the comparison circuitry 640 determines a charger connector is nearing a compatible port when the charging port 130 of FIGS. 1, 2, 4, and 6, corresponding to the detection circuitry 510 or 810, is the port the connector is approaching.

The indicator 125 indicates the cable is approaching an incompatible port in response to a first indication from the controller circuitry 520. (Block 1160). For example, the comparison circuitry 640 generates the first indication in response to determining that the connector is an HDMI connector and is approaching the charger port 130. In such an example, the indicator 125 illuminates RED to indicate to the user that the connector is approaching an incompatible port. The controller circuitry 120 sends another voltage pulse to the detection circuitry 510 or 810 when the connector is in proximity to an incompatible port. (Returns to Block 1110).

The indicator 125 indicates the cable is approaching a compatible port in response to a second indication from the controller circuitry 520. (Block 1170). For example, the comparison circuitry 640 generates the second indication in response to determining that the connector is a charger connector and is approaching the charger port 130. In such an example, the indicator 125 illuminates GREEN to indicate to the user that the connector is approaching a compatible port. The controller circuitry 520 ends the process of flowchart 1100 when the connector is approaching a compatible port.

Although example methods are described with reference to the flowchart 1100 illustrated in FIG. 11, many other methods of detecting whether an approaching connector is near a compatible port may alternatively be used in accordance with this description. For example, the order of execution of the blocks may be changed, and/or some of the blocks described may be changed, eliminated, or combined. Similarly, additional operations may be included in the manufacturing process before, in between, or after the blocks shown in the illustrated examples.

FIG. 12 is a block diagram of an example processor platform 1200 structured to execute and/or instantiate the machine readable instructions and/or the operations of FIGS. 10 and/or 11 to implement the controller circuitry of FIGS. 1, 2, 5, and 8. The processor platform 1200 can be, for example, a server, a personal computer, a workstation, a self-learning machine (e.g., a neural network), a mobile device (e.g., a cell phone, a smart phone, a tablet such as an iPad™), a personal digital assistant (PDA), an Internet appliance, a DVD player, a CD player, a digital video recorder, a Blu-ray player, a gaming console, a personal video recorder, a set top box, a headset (e.g., an augmented reality (AR) headset, a virtual reality (VR) headset, etc.) or other wearable device, or any other type of computing device.

The processor platform 1200 of the illustrated example includes processor circuitry 1212. The processor circuitry 1212 of the illustrated example is hardware. For example, the processor circuitry 1212 can be implemented by one or more integrated circuits, logic circuits, FPGAs, microprocessors, CPUs, GPUs, DSPs, and/or microcontrollers from any desired family or manufacturer. The processor circuitry 1212 may be implemented by one or more semiconductor based (e.g., silicon based) devices. In this example, the processor circuitry 1212 implements the controller circuitry 120 of FIGS. 1-3 and the controller circuitry 520 of FIGS. 5, 6, and 8.

The processor circuitry 1212 of the illustrated example includes a local memory 1213 (e.g., a cache, registers, etc.). The processor circuitry 1212 of the illustrated example is in communication with a main memory including a volatile memory 1214 and a non-volatile memory 1216 by a bus 1218. The volatile memory 1214 may be implemented by Synchronous Dynamic Random Access Memory (SDRAM), Dynamic Random Access Memory (DRAM), RAMBUS® Dynamic Random Access Memory (RDRAM®), and/or any other type of RAM device. The non-volatile memory 1216 may be implemented by flash memory and/or any other desired type of memory device. Access to the main memory 1214, 1216 of the illustrated example is controlled by a memory controller 1217.

The processor platform 1200 of the illustrated example also includes interface circuitry 1220. The interface circuitry 1220 may be implemented by hardware in accordance with any type of interface standard, such as an Ethernet interface, a universal serial bus (USB) interface, a Bluetooth® interface, a near field communication (NFC) interface, a Peripheral Component Interconnect (PCI) interface, and/or a Peripheral Component Interconnect Express (PCIe) interface.

In the illustrated example, one or more input devices 1222 are connected to the interface circuitry 1220. The input device(s) 1222 permit(s) a user to enter data and/or commands into the processor circuitry 1212. The input device(s) 1222 can be implemented by, for example, an audio sensor, a microphone, a camera (still or video), a keyboard, a button, a mouse, a touchscreen, a track-pad, a trackball, an isopoint device, and/or a voice recognition system.

One or more output devices 1224 are also connected to the interface circuitry 1220 of the illustrated example. The output device(s) 1224 can be implemented, for example, by display devices (e.g., a light emitting diode (LED), an organic light emitting diode (OLED), a liquid crystal display (LCD), a cathode ray tube (CRT) display, an in-place switching (IPS) display, a touchscreen, etc.), a tactile output device, a printer, and/or speaker. The interface circuitry 1220 of the illustrated example, thus, typically includes a graphics driver card, a graphics driver chip, and/or graphics processor circuitry such as a GPU.

The interface circuitry 1220 of the illustrated example also includes a communication device such as a transmitter, a receiver, a transceiver, a modem, a residential gateway, a wireless access point, and/or a network interface to facilitate exchange of data with external machines (e.g., computing devices of any kind) by a network 1226. The communication can be by, for example, an Ethernet connection, a digital subscriber line (DSL) connection, a telephone line connection, a coaxial cable system, a satellite system, a line-of-site wireless system, a cellular telephone system, an optical connection, etc.

The processor platform 1200 of the illustrated example also includes one or more mass storage devices 1228 to store software and/or data. Examples of such mass storage devices 1228 include magnetic storage devices, optical storage devices, floppy disk drives, HDDs, CDs, Blu-ray disk drives, redundant array of independent disks (RAID) systems, solid state storage devices such as flash memory devices and/or SSDs, and DVD drives.

The machine readable instructions 1232, which may be implemented by the machine readable instructions of FIGS. 10 and/or 11, may be stored in the mass storage device 1228, in the volatile memory 1214, in the non-volatile memory 1216, and/or on a removable non-transitory computer readable storage medium such as a CD or DVD.

FIG. 13 is a block diagram of an example implementation of the processor circuitry 1212 of FIG. 12. In this example, the processor circuitry 1212 of FIG. 12 is implemented by a microprocessor 1300. For example, the microprocessor 1300 may be a general purpose microprocessor (e.g., general purpose microprocessor circuitry). The microprocessor 1300 executes some or all of the machine readable instructions of the flowcharts of FIGS. 10 and/or 11 to effectively instantiate the circuitry of FIG. 3 as logic circuits to perform the operations corresponding to those machine readable instructions. In some such examples, the circuitry of FIG. 3 is instantiated by the hardware circuits of the microprocessor 1300 in combination with the instructions. For example, the microprocessor 1300 may be implemented by multi-core hardware circuitry such as a CPU, a DSP, a GPU, an XPU, etc. Although it may include any number of example cores 1302 (e.g., 1 core), the microprocessor 1300 of this example is a multi-core semiconductor device including N cores. The cores 1302 of the microprocessor 1300 may operate independently or may cooperate to execute machine readable instructions. For example, machine code corresponding to a firmware program, an embedded software program, or a software program may be executed by one of the cores 1302 or may be executed by multiple ones of the cores 1302 at the same or different times. In some examples, the machine code corresponding to the firmware program, the embedded software program, or the software program is split into threads and executed in parallel by two or more of the cores 1302. The software program may correspond to a portion or all of the machine readable instructions and/or operations represented by the flowcharts of FIGS. 10 and/or 11.

The cores 1302 may communicate by a first example bus 1304. In some examples, the first bus 1304 may be implemented by a communication bus to effectuate communication associated with one(s) of the cores 1302. For example, the first bus 1304 may be implemented by at least one of an Inter-Integrated Circuit (I2C) bus, a Serial Peripheral Interface (SPI) bus, a PCI bus, or a PCIe bus. Additionally or alternatively, the first bus 1304 may be implemented by any other type of computing or electrical bus. The cores 1302 may obtain data, instructions, and/or signals from one or more external devices by example interface circuitry 1306. The cores 1302 may output data, instructions, and/or signals to the one or more external devices by the interface circuitry 1306. Although the cores 1302 of this example include example local memory 1320 (e.g., Level 1 (L1) cache that may be split into an L1 data cache and an L1 instruction cache), the microprocessor 1300 also includes example shared memory 1310 that may be shared by the cores (e.g., Level 2 (L2 cache)) for high-speed access to data and/or instructions. Data and/or instructions may be transferred (e.g., shared) by writing to and/or reading from the shared memory 1310. The local memory 1320 of each of the cores 1302 and the shared memory 1310 may be part of a hierarchy of storage devices including multiple levels of cache memory and the main memory (e.g., the main memory 1214, 1216 of FIG. 12). Typically, higher levels of memory in the hierarchy exhibit lower access time and have smaller storage capacity than lower levels of memory. Changes in the various levels of the cache hierarchy are managed (e.g., coordinated) by a cache coherency policy.

Each core 1302 may be referred to as a CPU, DSP, GPU, etc., or any other type of hardware circuitry. Each core 1302 includes control unit circuitry 1314, arithmetic and logic (AL) circuitry (sometimes referred to as an ALU) 1316, a plurality of registers 1318, the local memory 1320, and a second example bus 1322. Other structures may be present. For example, each core 1302 may include vector unit circuitry, single instruction multiple data (SINM) unit circuitry, load/store unit (LSU) circuitry, branch/jump unit circuitry, floating-point unit (FPU) circuitry, etc. The control unit circuitry 1314 includes semiconductor-based circuits structured to control (e.g., coordinate) data movement within the corresponding core 1302. The AL circuitry 1316 includes semiconductor-based circuits structured to perform one or more mathematic and/or logic operations on the data within the corresponding core 1302. The AL circuitry 1316 of some examples performs integer based operations. In other examples, the AL circuitry 1316 also performs floating point operations. In yet other examples, the AL circuitry 1316 may include first AL circuitry that performs integer based operations and second AL circuitry that performs floating point operations. In some examples, the AL circuitry 1316 may be referred to as an Arithmetic Logic Unit (ALU). The registers 1318 are semiconductor-based structures to store data and/or instructions such as results of one or more of the operations performed by the AL circuitry 1316 of the corresponding core 1302. For example, the registers 1318 may include vector register(s), SIMD register(s), general purpose register(s), flag register(s), segment register(s), machine specific register(s), instruction pointer register(s), control register(s), debug register(s), memory management register(s), machine check register(s), etc. The registers 1318 may be arranged in a bank as shown in FIG. 13. Alternatively, the registers 1318 may be organized in any other arrangement, format, or structure including distributed throughout the core 1302 to shorten access time. The second bus 1322 may be implemented by at least one of an I2C bus, a SPI bus, a PCI bus, or a PCIe bus

Each core 1302 and/or, more generally, the microprocessor 1300 may include additional and/or alternate structures to those shown and described above. For example, one or more clock circuits, one or more power supplies, one or more power gates, one or more cache home agents (CHAs), one or more converged/common mesh stops (CMSs), one or more shifters (e.g., barrel shifter(s)) and/or other circuitry may be present. The microprocessor 1300 is a semiconductor device fabricated to include many transistors interconnected to implement the structures described above in one or more integrated circuits (ICs) contained in one or more packages. The processor circuitry may include and/or cooperate with one or more accelerators. In some examples, accelerators are implemented by logic circuitry to perform certain tasks more quickly and/or efficiently than can be done by a general purpose processor. Examples of accelerators include ASICs and FPGAs such as those discussed herein. A GPU or other programmable device can also be an accelerator. Accelerators may be on-board the processor circuitry, in the same chip package as the processor circuitry and/or in one or more separate packages from the processor circuitry.

FIG. 14 is a block diagram of another example implementation of the processor circuitry 1212 of FIG. 12. In this example, the processor circuitry 1212 is implemented by FPGA circuitry 1400. For example, the FPGA circuitry 1400 may be implemented by an FPGA. The FPGA circuitry 1400 can be used, for example, to perform operations that could otherwise be performed by the example microprocessor 1300 of FIG. 13 executing corresponding machine readable instructions. However, once configured, the FPGA circuitry 1400 instantiates the machine readable instructions in hardware and, thus, can often execute the operations faster than they could be performed by a general purpose microprocessor executing the corresponding software.

More specifically, in contrast to the microprocessor 1300 of FIG. 13 described above (which is a general purpose device that may be programmed to execute some or all of the machine readable instructions represented by the flowcharts of FIGS. 10 and/or 11 but whose interconnections and logic circuitry are fixed once fabricated), the FPGA circuitry 1400 of the example of FIG. 14 includes interconnections and logic circuitry that may be configured and/or interconnected in different ways after fabrication to instantiate, for example, some or all of the machine readable instructions represented by the flowcharts of FIGS. 10 and/or 11. In particular, the FPGA circuitry 1400 may be thought of as an array of logic gates, interconnections, and switches. The switches can be programmed to change how the logic gates are interconnected by the interconnections, effectively forming one or more dedicated logic circuits (unless and until the FPGA circuitry 1400 is reprogrammed). The configured logic circuits enable the logic gates to cooperate in different ways to perform different operations on data received by input circuitry. Those operations may correspond to some or all of the software represented by the flowcharts of FIGS. 10 and/or 11. As such, the FPGA circuitry 1400 may be structured to effectively instantiate some or all of the machine readable instructions of the flowcharts of FIGS. 10 and/or 11 as dedicated logic circuits to perform the operations corresponding to those software instructions in a dedicated manner analogous to an ASIC. Therefore, the FPGA circuitry 1400 may perform the operations corresponding to the some or all of the machine readable instructions of FIGS. 10 and/or 11 faster than the general purpose microprocessor can execute the same.

In the example of FIG. 14, the FPGA circuitry 1400 is structured to be programmed (and/or reprogrammed one or more times) by an end user by a hardware description language (HDL) such as Verilog. The FPGA circuitry 1400 of FIG. 14, includes example input/output (I/O) circuitry 1402 to obtain and/or output data to/from example configuration circuitry 1404 and/or external hardware 1406. For example, the configuration circuitry 1404 may be implemented by interface circuitry that may obtain machine readable instructions to configure the FPGA circuitry 1400, or portion(s) thereof. In some such examples, the configuration circuitry 1404 may obtain the machine readable instructions from a user, a machine (e.g., hardware circuitry (e.g., programmed or dedicated circuitry) that may implement an Artificial Intelligence/Machine Learning (AI/ML) model to generate the instructions), etc. In some examples, the external hardware 1406 may be implemented by external hardware circuitry. For example, the external hardware 1406 may be implemented by the microprocessor 1300 of FIG. 13. The FPGA circuitry 1400 also includes an array of example logic gate circuitry 1408, a plurality of example configurable interconnections 1410, and example storage circuitry 1412. The logic gate circuitry 1408 and the configurable interconnections 1410 are configurable to instantiate one or more operations that may correspond to at least some of the machine readable instructions of FIGS. 10 and/or 11 and/or other desired operations. The logic gate circuitry 1408 shown in FIG. 14 is fabricated in groups or blocks. Each block includes semiconductor-based electrical structures that may be configured into logic circuits. In some examples, the electrical structures include logic gates (e.g., And gates, Or gates, Nor gates, etc.) that provide basic building blocks for logic circuits. Electrically controllable switches (e.g., transistors) are present within each of the logic gate circuitry 1408 to enable configuration of the electrical structures and/or the logic gates to form circuits to perform desired operations. The logic gate circuitry 1408 may include other electrical structures such as look-up tables (LUTs), registers (e.g., flip-flops or latches), multiplexers, etc.

The configurable interconnections 1410 of the illustrated example are conductive pathways, traces, vias, or the like that may include electrically controllable switches (e.g., transistors) whose state can be changed by programming (e.g., using an HDL instruction language) to activate or deactivate one or more connections between one or more of the logic gate circuitry 1408 to program desired logic circuits.

The storage circuitry 1412 of the illustrated example is structured to store result(s) of the one or more of the operations performed by corresponding logic gates. The storage circuitry 1412 may be implemented by registers or the like. In the illustrated example, the storage circuitry 1412 is distributed amongst the logic gate circuitry 1408 to facilitate access and increase execution speed.

The example FPGA circuitry 1400 of FIG. 14 also includes example Dedicated Operations Circuitry 1414. In this example, the Dedicated Operations Circuitry 1414 includes special purpose circuitry 1416 that may be invoked to implement commonly used functions to avoid the need to program those functions in the field. Examples of such special purpose circuitry 1416 include memory (e.g., DRAM) controller circuitry, PCIe controller circuitry, clock circuitry, transceiver circuitry, memory, and multiplier-accumulator circuitry. Other types of special purpose circuitry may be present. In some examples, the FPGA circuitry 1400 may also include example general purpose programmable circuitry 1418 such as an example CPU 1420 and/or an example DSP 1422. Other general purpose programmable circuitry 1418 may additionally or alternatively be present such as a GPU, an XPU, etc., that can be programmed to perform other operations.

Although FIGS. 13 and 14 illustrate two example implementations of the processor circuitry 1212 of FIG. 12, many other approaches are contemplated. For example, as mentioned above, modern FPGA circuitry may include an on-board CPU, such as one or more of the example CPU 1420 of FIG. 14. Therefore, the processor circuitry 1212 of FIG. 12 may additionally be implemented by combining the example microprocessor 1300 of FIG. 13 and the example FPGA circuitry 1400 of FIG. 14. In some such hybrid examples, a first portion of the machine readable instructions represented by the flowcharts of FIGS. 10 and/or 11 may be executed by one or more of the cores 1302 of FIG. 13, a second portion of the machine readable instructions represented by the flowcharts of FIGS. 10 and/or 11 may be executed by the FPGA circuitry 1400 of FIG. 14, and/or a third portion of the machine readable instructions represented by the flowcharts of FIGS. 10 and/or 11 may be executed by an ASIC. It should be understood that some or all of the circuitry of FIGS. 3 and/or 6 may, thus, be instantiated at the same or different times. Some or all of the circuitry may be instantiated, for example, in one or more threads executing concurrently and/or in series. Moreover, in some examples, some or all of the circuitry of FIGS. 3 and/or 6 may be implemented within one or more virtual machines and/or containers executing on the microprocessor.

In some examples, the processor circuitry 1212 of FIG. 12 may be in one or more packages. For example, the microprocessor 1300 of FIG. 13 and/or the FPGA circuitry 1400 of FIG. 14 may be in one or more packages. In some examples, an XPU may be implemented by the processor circuitry 1212 of FIG. 12, which may be in one or more packages. For example, the XPU may include a CPU in one package, a DSP in another package, a GPU in yet another package, and an FPGA in still yet another package.

From the foregoing, it will be appreciated that example systems, methods, apparatus, and articles of manufacture have been disclosed that detect whether a connector is approaching a compatible port.

The following claims are hereby incorporated into this Detailed Description by this reference. Although certain example systems, methods, apparatus, and articles of manufacture have been disclosed herein, the scope of coverage of this patent is not limited thereto. On the contrary, this patent covers all systems, methods, apparatus, and articles of manufacture fairly falling within the scope of the claims of this patent.

Example methods, apparatus, systems, and articles of manufacture to detect a compatible port are disclosed herein. Further examples and combinations thereof include the following: Example 1 includes an apparatus comprising detection circuitry including an inductor and a capacitor, and controller circuitry coupled to the detection circuitry, the controller circuitry configured to generate a voltage pulse, supply the voltage pulse to the detection circuitry, monitor a characteristic of a detection output of the detection circuitry in response to the voltage pulse, determine a variation in the detection output based on a comparison of the characteristic of the detection output to a threshold value, and determine a type of a connector in proximity to the detection circuitry based on the variation.

Example 2 includes the apparatus of example 1, wherein the detection circuitry is configured to modify a resonant frequency of the detection output by varying an inductance of the inductor.

Example 3 includes the apparatus of example 1, wherein the detection circuitry is configured to modify a voltage of the detection output based on a reverse electromotive force (EMF) of the inductor.

Example 4 includes the apparatus of example 1, wherein the inductor is a first inductor, the detection circuitry further including a second inductor, the second inductor configured to be magnetically coupled to the first inductor when the connector is in proximity to the detection circuitry.

Example 5 includes the apparatus of example 4, wherein the detection circuitry is configured to modify a voltage of the detection output based on a magnitude of current induced in the second inductor by the first inductor.

Example 6 includes the apparatus of example 1, wherein the characteristic of the detection output is one of a resonant frequency, a local maximum voltage, or an average voltage.

Example 7 includes the apparatus of example 1, wherein the controller circuitry is further configured to determine a first time that a voltage of the detection output is equal to a reference voltage, determine a second time that the voltage of the detection output is equal to the reference voltage, and determine a resonant frequency of the detection circuitry based on a difference between the first time and the second time.

Example 8 includes the apparatus of example 1, wherein the controller circuitry is further configured to generate a first indication in response to determining the type of the connector is compatible with a port in proximity to the detection circuitry and generate a second indication in response to determining the type of the connector is incompatible with the port in proximity to the detection circuitry.

Example 9 includes a non-transitory machine readable storage medium comprising instructions that, when executed, cause processor circuitry to at least generate a voltage pulse, supply the voltage pulse to detection circuitry, monitor a characteristic of a detection output of the detection circuitry in response to the voltage pulse, determine a variation in the detection output based on a comparison of the characteristic of the detection output to a threshold value, and determine a type of a connector in proximity to the detection circuitry based on the variation.

Example 10 includes the non-transitory machine readable storage medium of example 9, further comprising instructions that, when executed, cause processor circuitry to determine the variation of a resonant frequency of the detection output caused by varying an inductance of an inductor.

Example 11 includes the non-transitory machine readable storage medium of example 9, further comprising instructions that, when executed, cause processor circuitry to determine the variation to a voltage of the detection output in response to a reverse electromotive force (EMF) on an inductor.

Example 12 includes the non-transitory machine readable storage medium of example 9, further comprising instructions that, when executed, cause processor circuitry to determine the variation to a voltage of the detection output caused by variations in a magnitude of current induced in a first inductor by a second inductor.

Example 13 includes the non-transitory machine readable storage medium of example 9, further comprising instructions that, when executed, cause processor circuitry to determine the characteristic of the detection output as one of a resonant frequency, a local maximum voltage, or an average voltage.

Example 14 includes the non-transitory machine readable storage medium of example 9, further comprising instructions that, when executed, cause processor circuitry to determine a first time that a voltage of the detection output is equal to a reference voltage, determine a second time that the voltage of the detection output is equal to the reference voltage, and determine a resonant frequency of the detection circuitry based on a difference between the first time and the second time.

Example 15 includes the non-transitory machine readable storage medium of example 9, further comprising instructions that, when executed, cause processor circuitry to generate a first indication in response to determining the type of the connector is compatible with a port in proximity to the detection circuitry and generate a second indication in response to determining the type of the connector is incompatible with the port in proximity to the detection circuitry.

Example 16 includes a method comprising generating, by pulse generator circuitry, a voltage pulse, supplying, by the pulse generator circuitry, the voltage pulse to detection circuitry, monitoring, by controller circuitry, a characteristic of a detection output of the detection circuitry in response to the voltage pulse, determining, by comparison circuitry, a variation in the detection output based on a comparison of the characteristic of the detection output to a threshold value, and determining, by the comparison circuitry, a type of a connector in proximity to the detection circuitry based on a magnitude of the variation.

Example 17 includes the method of example 16, further comprising modifying a resonant frequency of the detection output by varying an inductance of an inductor.

Example 18 includes the method of example 16, further comprising modifying a voltage of the detection output based on a reverse electromotive force (EMF) on an inductor.

Example 19 includes the method of example 16, further comprising modifying a voltage of the detection output based on a magnitude of current induced in an inductor.

Example 20 includes the method of example 16, wherein the characteristic of the detection output is one of a resonant frequency, a local maximum voltage, or an average voltage.

Example 21 includes the method of example 16, further comprising determining a first time that a voltage of the detection output is equal to a reference voltage, determining a second time that the voltage of the detection output is equal to the reference voltage, and determining a resonant frequency of the detection circuitry based on a difference between the first time and the second time.

Example 22 includes the method of example 16, further comprising generating a first indication in response to determining the type of the connector is compatible with a port in proximity to the detection circuitry and generating a second indication in response to determining the type of the connector is incompatible with the port in proximity to the detection circuitry.

**Claims**

1. A method comprising:

   generating, by pulse generator circuitry, a voltage pulse;
   supplying, by the pulse generator circuitry, the voltage pulse to detection circuitry;
   monitoring, by controller circuitry, a characteristic of a detection output of the detection circuitry in response to the voltage pulse;
   determining, by comparison circuitry, a variation in the detection output based on a comparison of the characteristic of the detection output to a threshold value; and
   determining, by the comparison circuitry, a type of a connector in proximity to the detection circuitry based on a magnitude of the variation.

2. The method of claim 1, further including modifying a resonant frequency of the detection output by varying an inductance of an inductor.

3. The method of one of the previous claims, further including modifying a voltage of the detection output based on a reverse electromotive force (EMF) on an inductor.

4. The method of one of the previous claims, further including modifying a voltage of the detection output based on a magnitude of current induced in an inductor.

5. The method of one of the previous claims, wherein the characteristic of the detection output is one of a resonant frequency, a local maximum voltage, or an average voltage.

6. The method of one of the previous claims, further including at least one of:

   determining a first time that a voltage of the detection output is equal to a reference voltage;
   determining a second time that the voltage of the detection output is equal to the reference voltage; and
   determining a resonant frequency of the detection circuitry based on a difference between the first time and the second time.

7. The method of one of the previous claims, further including at least one of:

   generating a first indication in response to determining the type of the connector is compatible with a port in proximity to the detection circuitry; and
   generating a second indication in response to determining the type of the connector is incompatible with the port in proximity to the detection circuitry.

8. An apparatus comprising:

   detection circuitry including an inductor and a capacitor; and
   controller circuitry coupled to the detection circuitry, the controller circuitry configured to:

      generate a voltage pulse;
      supply the voltage pulse to the detection circuitry;
      monitor a characteristic of a detection output of the detection circuitry in response to the voltage pulse;
      determine a variation in the detection output based on a comparison of the characteristic of the detection output to a threshold value; and
      determine a type of a connector in proximity to the detection circuitry based on the variation.

9. The apparatus of claim 8, wherein the inductor is a first inductor, the detection circuitry further including a second inductor, the second inductor configured to be magnetically coupled to the first inductor when the connector is in proximity to the detection circuitry, and the detection circuitry is configured to modify a voltage of the detection output based on a magnitude of current induced in the second inductor by the first inductor.

10. The apparatus of claim 8 or 9, wherein the characteristic of the detection output is one of a resonant frequency, a local maximum voltage, or an average voltage.

11. The apparatus of claim 8, 9 or 10, wherein the controller circuitry is further configured to:

determine a first time that a voltage of the detection output is equal to a reference voltage;
determine a second time that the voltage of the detection output is equal to the reference voltage; and
determine a resonant frequency of the detection circuitry based on a difference between the first time and the second time.

12. Machine-readable storage including machine-readable instructions, when executed, cause processor circuitry to at least:

generate a voltage pulse;
supply the voltage pulse to detection circuitry;
monitor a characteristic of a detection output of the detection circuitry in response to the voltage pulse;
determine a variation in the detection output based on a comparison of the characteristic of the detection output to a threshold value; and
determine a type of a connector in proximity to the detection circuitry based on the variation.

13. The machine-readable storage of claim 12, further comprising machine-readable instructions that, when executed, cause processor circuitry to determine the variation of a resonant frequency of the detection output caused by varying an inductance of an inductor.

14. The machine-readable storage of claim 12 or 13, further comprising machine-readable instructions that, when executed, cause processor circuitry to determine the variation to a voltage of the detection output in response to a reverse electromotive force (EMF) on an inductor.

15. The machine-readable storage of claim 12, 13 or 14, further comprising machine-readable instructions that, when executed, cause processor circuitry to:

generate a first indication in response to determining the type of the connector is compatible with a port in proximity to the detection circuitry; and
generate a second indication in response to determining the type of the connector is incompatible with the port in proximity to the detection circuitry.

FIG. 1

FIG. 2

EP 4 345 472 A1

**FIG. 3**

FIG. 4A

FIG. 4B

EP 4 345 472 A1

500

130
PORT

540
530
550
560
570 580
Detect_OUT
520
CONTROLLER
CIRCUITRY
125
INDICATOR
$V_{IN}$
2 2 - 2
510
TO/FROM ADDITIONAL
DETECTION CIRCUITRY

**FIG. 5**

TO INDICATION

520

610

670 — PULSE GENERATOR CIRCUITRY

660 — TIMER CIRCUITRY

680 — ANALOG-TO-DIGITAL CONVERTER CIRCUITRY

650

MEMORY

COMPARISON CIRCUITRY

640

VOLTAGE MONITOR

620 / 630 — VOLTAGE MONITOR

VOLTAGE MONITOR

TO/FROM DETECTION CIRCUITRY

**FIG. 6**

FIG. 7A

FIG. 7B

EP 4 345 472 A1

FIG. 8

**FIG. 9A**

**FIG. 9B**

1000

```
                          ┌─────────┐
                          │  START  │
                          └─────────┘
                               │
                               ▼
1010   ┌──────────────────────────────────────────────┐
       │  SUPPLY A VOLTAGE PULSE TO DETECTION          │
       │  CIRCUITRY                                    │
       └──────────────────────────────────────────────┘
                               │
                               ▼
1020   ┌──────────────────────────────────────────────┐
       │ DETERMINE A REFERENCE COUNT OF A DETECTION    │
       │ OUTPUT OF THE DETECTION CIRCUITRY             │
       └──────────────────────────────────────────────┘
                               │
                               ▼
1030   ◁──────────────────────────────────────────────▷  NO
        │      IS A CABLE IN PROXIMITY OF DEVICE?      │─────►
        ◁──────────────────────────────────────────────▷
                               │ YES
                               ▼
1040   ┌──────────────────────────────────────────────┐
       │ DETERMINE A COMPATIBLE PORT BASED ON THE      │
       │ REFERENCE COUNT                               │
       └──────────────────────────────────────────────┘
                               │
                               ▼
1050   ◁──────────────────────────────────────────────▷
        │        IS THE CABLE NEAR THE COMPATIBLE      │
 YES    │                   PORT?                      │
        ◁──────────────────────────────────────────────▷
                               │ NO
                               ▼
1060   ┌──────────────────────────────────────────────┐
       │          INDICATE INCOMPATIBLE PORT           │
       └──────────────────────────────────────────────┘

1070   ┌──────────────────────────────────────────────┐
       │          INDICATE COMPATIBLE PORT             │
       └──────────────────────────────────────────────┘
                               │
                               ▼
                          ┌─────────┐
                          │   END   │
                          └─────────┘
```

**FIG. 10**

1100

START

1110 — SUPPLY A VOLTAGE PULSE TO DETECTION CIRCUITRY

1120 — MEASURE A VOLTAGE OF A DETECTION OUTPUT OF THE DETECTION CIRCUITRY

1130 — IS A CABLE IN PROXIMITY OF DEVICE? — NO

YES

1140 — DETERMINE A COMPATIBLE PORT BASED ON THE VOLTAGE OF THE DETECTION OUTPUT

1150 — IS THE CABLE NEAR THE COMPATIBLE PORT?

YES

NO

1160 — INDICATE INCOMPATIBLE PORT

1170 — INDICATE COMPATIBLE PORT

END

**FIG. 11**

EP 4 345 472 A1

FIG. 12

38

FIG. 13

CONFIGURATION CIRCUITRY 1404

EXTERNAL HARDWARE 1406

FIELD PROGRAMMABLE GATE ARRAY (FPGA) CIRCUITRY 1400

1412 — 1408
1410
1412 — 1408
1412 — 1408

LOGIC GATE CIRCUITRY (LGC)

| I |

LGC

| I |

LGC

1410

1402
1410
1410
1410

| I |

INTERCONNECTIONS (I)

| I |

INPUT / OUTPUT (I/O) CIRCUITRY

1412 —
1410 —
1412 —
1410
1412 — 1408

LGC

| I |

LGC

| I |

LGC

1408
1408

STORAGE CIRCUITRY

1410
1410
1410

| I |

| I |

| I |

1412
1408

1412 —
1410 —
1412
1408

LGC

| I |

LGC

| I |

LGC

1408
1408
1410

DEDICATED OPERATIONS CIRCUITRY 1414

SPECIAL PURPOSE CIRCUITRY 1416

| MEMORY CONTROLLER CIRCUITRY | CLOCK CIRCUITRY | PCIE CONTROLLER CIRCUITRY | MULTIPLIER ACCUMULATOR CIRCUITRY (MAC) |

GENERAL PURPOSE PROGRAMMABLE CIRCUITRY 1418

| CENTRAL PROCESSING UNIT (CPU) | 1420 | DIGITAL SIGNAL PROCESSOR (DSP) | 1422 |

FIG. 14

Europäisches
Patentamt

European
Patent Office

Office européen
des brevets

# EUROPEAN SEARCH REPORT

**Application Number**

**EP 23 19 3693**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/211397 A1 (LIN TAY-YANG [TW] ET AL) 31 July 2014 (2014-07-31) | 1,8,12 | INV. G01R31/69 |
| Y | * abstract * <br> * paragraphs [0015], [0023] * <br> * claims 10-18 * | 2-7, 9-11, 13-15 | G06F1/16 <br> G06F1/18 |
| Y | Walsh Paul ET AL: "Inductive Sensing Design Guide", <br> , <br> 31 December 2019 (2019-12-31), pages 1-48, XP093121286, <br> Retrieved from the Internet: <br> URL:https://www.infineon.com/dgdl/Infineon -AN219207_Inductive_Sensing_Design_Guide-A pplicationNotes-v04_00-EN.pdf?fileId=8ac78 c8c7cdc391c017d0d358bd5662c <br> [retrieved on 2024-01-18] <br> * abstract * <br> * page 2 * <br> * page 4 * <br> * figure 3 * | 2-7, 9-11, 13-15 | |
| A | US 2016/014390 A1 (LIGTENBERG CHRISTIAAN A [US] ET AL) 14 January 2016 (2016-01-14) <br> * abstract * <br> * claim 5 * <br> * claim 14 * | 1-15 | TECHNICAL FIELDS SEARCHED (IPC) <br><br> G01R <br> G06F <br> H01R |
| A | US 2015/002296 A1 (BELL DENNIS [US]) 1 January 2015 (2015-01-01) <br> * abstract * <br> * figure 3 * | 1-15 | |

-/--

The present search report has been drawn up for all claims

| Place of search | Date of completion of the search | Examiner |
|---|---|---|
| The Hague | 22 January 2024 | Stoffers, Christian |

EPO FORM 1503 03.82 (P04C01)

page 1 of 2

Europäisches
Patentamt
European
Patent Office
Office européen
des brevets

# EUROPEAN SEARCH REPORT

Application Number

EP 23 19 3693

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Tu Dortmund: "Inhalt der Vorlesung A1 1. Einführung Methode der Physik Physikalische Größen Übersicht über die vorgesehenen Themenbereiche 2. Teilchen A. Einzelne Teilchen Beschreibung von Teilchenbewegung Kinematik: Quantitative Erfassung Dynamik: Ursachen der Bewegung Kräfte Arbeit + Leistung, Energie Erhaltung", , 31 October 2019 (2019-10-31), pages 1-60, XP93121649, Retrieved from the Internet: URL:https://e2.physik.tu-dortmund.de/storages/e2-physik/r/Teaching/WS19_20/A2-07-WS1920.pdf [retrieved on 2024-01-19] * pages 39,41,49 * ----- | 1-15 | |

TECHNICAL FIELDS
SEARCHED (IPC)

The present search report has been drawn up for all claims

| Place of search | Date of completion of the search | Examiner |
|---|---|---|
| The Hague | 22 January 2024 | Stoffers, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 19 3693

This annex lists the patent family members relating to the patent documents cited in the above-mentioned European search report.
The members are as contained in the European Patent Office EDP file on
The European Patent Office is in no way liable for these particulars which are merely given for the purpose of information.

22-01-2024

| Patent document cited in search report | Publication date | Patent family member(s) | Publication date |
|---|---|---|---|
| US 2014211397 A1 | 31-07-2014 | JP 2014150060 A<br>TW 201430560 A<br>US 2014211397 A1 | 21-08-2014<br>01-08-2014<br>31-07-2014 |
| US 2016014390 A1 | 14-01-2016 | NONE | |
| US 2015002296 A1 | 01-01-2015 | NONE | |

EPO FORM P0459

For more details about this annex : see Official Journal of the European Patent Office, No. 12/82